# EUROPEAN PATENT APPLICATION

(11) **EP 4 632 416 A1**
(43) Date of publication of application: **15.10.2025**
(21) Application number: 23905279.8
(22) Date of filing: 15.08.2023
(51) Int. Cl.: G01R 31/69, G01R 31/54

(54) **POGO PIN INTERFACE CONNECTION STATE DETECTION METHOD, COMBINATION APPARATUS AND ELECTRONIC DEVICE**

(30) Priority: 23.12.2022 CN 202211662608
(71) Applicant: Honor Device Co., Ltd., Shenzhen, Guangdong 518040 (CN)
(72) Inventor: TONG, Siyu, Shenzhen, Guangdong 518040 (CN)
(74) Representative: Isarpatent
(86) International application number: PCT/CN2023/113097
(87) International publication number: WO 2024/131100

(57) **Abstract**

This application discloses a pogo pin interface connection status detection method, a combination apparatus, and an electronic device, and relates to the field of communication technologies. The pogo pin interface connection status detection method is applied to an electronic device including a pogo pin interface and a sensor. The pogo pin interface includes a communication interface. The electronic device measures a distance between an external device and the electronic device by using the sensor. The electronic device sends a first instruction to the external device through a pogo pin communication interface if the distance is less than a preset threshold. The electronic device sends, if the electronic device does not receive a first response within first duration, first prompt information to prompt a user that a communication connection is not established between the external device and the electronic device. The electronic device obtains a status of a physical connection between the electronic device and the external device by using the sensor, determines a status of a communication connection between the external device and the electronic device through a response of the pogo pin communication interface, and sends prompt information when detecting that the communication connection is not established between the external device and the electronic device, to feed back a connection status of the external device to the user, so that user experience is optimized.

## Description

This application claims priority to Chinese Patent Application No. 202211662608.1, filed with the China National Intellectual Property Administration on December 23, 2022 and entitled "POGO PIN INTERFACE CONNECTION STATUS DETECTION METHOD, COMBINATION APPARATUS, AND ELECTRONIC DEVICE", which is incorporated herein by reference in its entirety.

### TECHNICAL FIELD

This application relates to the field of communication technologies, and in particular, to a pogo pin interface connection status detection method, a combination apparatus, and an electronic device.

### BACKGROUND

As functions of electronic devices such as tablet computers and notebook computers are upgraded, an external device connected by using a pogo pin, for example, a detachable keyboard connected by using a pogo pin, is increasingly used in an electronic device. The detachable keyboard attaches to a pogo pin interface of the electronic device through a pogo pin interface of the detachable keyboard to implement a physical connection, and data transmission may be performed between the detachable keyboard and the electronic device through the pogo pin interface to implement a communication connection.

In a process in which a user actually uses the detachable keyboard, a position of the detachable keyboard may change. Consequently, a position offset is generated when the pogo pin interface of the detachable keyboard is in contact with the pogo pin interface of the electronic device, and the detachable keyboard is disconnected from the electronic device. As a result, normal communication cannot be performed.

However, the user cannot sense an actual status of the detachable keyboard accurately and in a timely manner, and can find, only when the detachable keyboard needs to be used, that the detachable keyboard has been disconnected. In this case, the detachable keyboard is manually connected again, causing poor use experience of the user.

### SUMMARY

Embodiments of this application provide a pogo pin interface connection status detection method, a combination apparatus, and an electronic device. The electronic device may obtain a status of a physical connection and a status of a communication connection between the electronic device and an external device in real time, so that a user can learn of a connection status of a detachable keyboard in a timely manner, thereby optimizing user experience. To achieve the foregoing objective, the following technical solutions are used in embodiments of this application.

According to a first aspect, a pogo pin interface connection status detection method is provided, applied to an electronic device. The electronic device includes a pogo pin interface and a sensor. The pogo pin interface includes a communication interface. The method includes:

The electronic device measures a distance between an external device and the electronic device by using the sensor; the electronic device sends a first instruction to the external device through the communication interface if the distance is less than a preset threshold; and the electronic device sends first prompt information if the electronic device does not receive a first response within first duration, where the first prompt information prompts a user that a communication connection is not established between the external device and the electronic device.

In this application, the first instruction may be a test instruction, and correspondingly, the first response is a test response. The first instruction may alternatively be a communication instruction, and correspondingly the first response is a communication response. After the electronic device is physically connected to the external device, when the distance between the external device and the electronic device is less than the preset threshold, the electronic device sends the first instruction to the external device, to detect a status of a communication connection between the external device and the electronic device.

In this application, when the electronic device may measure the distance between the external device and the electronic device, it is determined that the electronic device establishes a physical connection with the external device when it is determined that the distance is less than the preset threshold. Therefore, the electronic device detects the communication connection through the communication interface, and when no response from the external device is obtained, the electronic device sends corresponding prompt information to prompt the user that the communication connection between the external device and the electronic device is abnormal. The electronic device may obtain a status of the physical connection and a status of the communication connection between the external device and the electronic device in real time, and send prompt information to remind the user when detecting that the communication connection is not established between the external device and the electronic device, so that the user can accurately sense an actual connection status of the external device in real time, and the user does not need to determine, by using the external device, whether the connection between the external device and the electronic device is abnormal, thereby improving user experience.

With reference to the first aspect, in a possible design, that the electronic device sends the first instruction to the external device through the communication interface includes:

The electronic device sends the first instruction to the external device through the communication interface based on a first periodicity.

In this application, the first periodicity may be a long periodicity. The first instruction sent by the electronic device may be a polling instruction within the long periodicity. The electronic device sends the first instruction when detecting that the distance between the external device and the electronic device is less than the preset threshold. In other words, the electronic device determines that a physical connection between the external device and the electronic device is normal. In this case, the first periodicity may be the long periodicity. By sending the polling instruction for the long periodicity, the electronic device may obtain an actual connection status of the external device in real time.

With reference to the first aspect, in a possible design, before the electronic device sends the first prompt information, the method further includes:

The electronic device sends a second instruction to the external device through the communication interface based on a second periodicity, and the electronic device receives no second response within second duration, where the second periodicity is shorter than the first periodicity.

In this application, the second periodicity is different from the first periodicity, and the second periodicity is a short periodicity. When not receiving the first response, the electronic device determines that the communication connection to the external device is abnormal. In this case, the electronic device may quickly detect the external device. To be specific, when the electronic device determines that the communication connection is not established between the external device and the electronic device, the electronic device may send the second instruction to the external device based on a specific short periodicity, and continuously detect the status of the communication connection between the external device and the electronic device. The second instruction may be a test instruction, or may be a communication instruction. The electronic device performs detection with the short periodicity to quickly determine whether the communication connection between the external device and the electronic device is really disconnected. When receiving no second response, the electronic device determines that communication between the external device and the electronic device is abnormal and outputs the first prompt information, so that connection status detection is more timely and accurate.

With reference to the first aspect, in a possible design, the method further includes:
The electronic device receives the second response through the communication interface within the second duration, and the electronic device does not receive the second response within the second duration.

In this application, during detection in the short periodicity, if the electronic device receives the second response within the second duration, it indicates that the communication connection between the electronic device and the external device is normal, and the electronic device may display external device connection information on a display interface. The second response is received by sending the second instruction when the first response is not received, so that accidentalness of a first response result is avoided, and a result of communication connection detection on the external device is more accurate.

With reference to the first aspect, in a possible design, that the electronic device sends the first prompt information includes:
The electronic device displays the first prompt information; or the electronic device plays the first prompt information.

In this application, when the electronic device does not receive the first response and determines that the communication connection between the external device and the electronic device is disconnected, the electronic device may display the first prompt information on the display interface, for example, display the first prompt information in a form of a pop-up window. Alternatively, the electronic device may play the first prompt information through a voice. Alternatively, the electronic device may play first reminding information in another audio output manner.

With reference to the first aspect, in a possible design, the method further includes:
The electronic device displays the external device connection information if the electronic device receives the first response within the first duration.

In this application, the first duration is time for which the electronic device waits to receive the first response from the external device. The first duration may be determined according to an actual communication status. When the electronic device receives the first response within the first duration and determines that the communication connection is established between the external device and the electronic device, the electronic device may display the external device connection information on the display interface. For example, prompt information indicating that the external device has been connected is displayed on the display interface by using a pop-up box. Alternatively, an icon of the external device is displayed in a status bar of the display interface, to indicate that the external device has been connected. In this way, the user can timely and intuitively obtain a connection status of the external device, so that the user can normally use the external device.

With reference to the first aspect, in a possible design, that the electronic device sends the first prompt information includes:
The electronic device stops displaying the external device connection information.

In this application, when the electronic device does not receive the first response and determines that the communication connection between the external device and the electronic device is disconnected, the electronic device stops displaying the external device connection information, for example, stops displaying the icon of the external device in the status bar of the display interface. Optionally, the electronic device may alternatively stop displaying the icon of the external device in the status bar of the display interface while displaying the first prompt information in the form of the pop-up window on the display interface. The user not only can determine the status of the communication connection of the external device depending on whether the icon of the external device in the status bar is displayed, but also can learn of the connection status of the external device more intuitively by using the pop-up window of the display interface, so that use experience of the user is optimized.

With reference to the first aspect, in a possible design, that the distance is less than the preset threshold includes:
The electronic device detects that a high-low level jump occurs in a level of the sensor.

In this application, the distance between the electronic device and the external device is determined through detection of the level of the sensor. When the external device approaches the electronic device, for example, the external device is physically connected to the electronic device, and the distance between the external device and the electronic device is less than the preset threshold, the electronic device detects that a jump occurs in the level of the sensor from a high level to a low level. Alternatively, when the distance between the external device and the electronic device is less than the preset threshold, the electronic device detects that a jump occurs in the level of the sensor from a low level to a high level. A specific principle of a high-low level jump occurring in a level of the sensor may be determined according to an actual situation. In this way, the electronic device determines, based on a change state of the level of the sensor, whether the external device approaches the electronic device, to determine a status of the physical connection between the external device and the electronic device, so that a detection result of the connection status is more accurate.

With reference to the first aspect, in a possible design, that the high-low level jump occurs in the level of the sensor includes:
The level of the sensor changes from a high level to a low level; or the level of the sensor changes from a low level to a high level; or a low level is restored after a high level interrupt is generated when the level of the sensor is at the low level; or a high level is restored after a low level interrupt is generated when the level of the sensor is at the high level.

In this application, the electronic device may define a rule of the high-low level jump of a level of a specific sensor when the distance between the external device and the electronic device is less than the preset threshold. When it is detected that the high-low level jump of the level of the sensor conforms to an agreed rule, it is determined that the distance between the external device and the electronic device is less than the preset threshold, and the external device is physically connected to the electronic device, to obtain the status of the physical connection between the external device and the electronic device. The determining solution is simple.

With reference to the first aspect, in a possible design, the pogo pin interface further includes a power interface, and after the electronic device detects that the high-low level jump occurs in the level of the sensor, the method further includes:
The electronic device controls the power interface to be powered up.

In this application, when it is detected that the high-low level jump of the level of the sensor conforms to the agreed rule, it is determined that the distance between the external device and the electronic device is less than the preset threshold, and when it is determined that the external device is physically connected to the electronic device, the electronic device controls the power interface to be powered up. The power interface of the electronic device supplies power to a power interface of the external device, so that a communication connection is performed.

With reference to the first aspect, in a possible design, after the electronic device detects that the high-low level jump occurs in the level of the sensor, the method further includes:
The electronic device sends a third instruction to the external device through the communication interface if the electronic device detects again that the high-low level jump occurs in the level of the sensor; and the electronic device controls the power interface to be powered down if the electronic device does not receive a third response within third duration.

In this application, if detecting that the high-low level jump occurs in the level of the sensor within a period of time, the electronic device sends the third instruction to the external device, and does not receive the third response within the third duration. In this case, the electronic device may determine that the sensor may be triggered by mistake, and actually no external device is connected to the electronic device. In this way, the electronic device may control the power interface to be powered down in a timely manner, so that a danger caused by a short circuit due to controlling the power interface to be powered up is avoided. The third duration may be time for which the electronic device waits to receive the third response from the external device. The third duration may be determined according to an actual communication status.

With reference to the first aspect, in a possible design, before the electronic device sends the first prompt information, the method further includes:
The electronic device detects that the high-low level jump does not occur in the level of the sensor within a preset time period, and the electronic device sends a fourth instruction to the external device through the communication interface; and the electronic device receives no fourth response within fourth duration.

In this application, if the electronic device detects that the high-low level jump occurs in the level of the sensor within a period of time, the electronic device determines that the physical connection between the external device and the electronic device is not disconnected. In this case, the electronic device sends the fourth instruction to the external device for detection, and if receiving the fourth response, the electronic device still continuously displays the external device connection information. If the fourth response is not received within the fourth duration, the electronic device sends the first reminding information, to prompt the user in a timely manner that the communication connection is disconnected. In this application, the electronic device detects the level of the sensor within the preset time period, to further determine the status of the physical connection between the electronic device and the external device. The fourth duration is time for which the electronic device waits to receive the fourth response from the external device. The fourth duration may be determined according to an actual communication status.

With reference to the first aspect, in a possible design, the method further includes:
The electronic device sends a fifth instruction to the external device through a first communication interface, where the first communication interface is any one of a plurality of communication interfaces; and the electronic device displays second prompt information if the electronic device received a fifth response not through the first communication interface within fifth duration, where the second prompt information prompts that the first communication interface is abnormal.

In this application, with reference to a scenario in which the electronic device and the external device have a plurality of communication interfaces, in an example, the electronic device sends the fifth instruction through the first communication interface, and in a normal communication connection situation, the electronic device receives the fifth response through the first communication interface within the fifth duration. If the electronic device does not receive the fifth response through the first communication interface within the fifth duration, it is determined that the first communication interface is abnormal. Communication manners of the communication interfaces are agreed on in a communication protocol between the electronic device and the external device. Therefore, in a communication process, one or more communication interfaces having an anomaly may be determined. Further, the electronic device may output, to the user, information indicating that the communication interface is abnormal. In this way, the user can maintain the communication interface in a timely manner, so that fault costs between the electronic device and the external device are reduced, and user experience is optimized. The fifth duration is time for which the electronic device waits to receive the fifth response from the external device, and the fifth duration may be determined according to an actual communication status.

With reference to the first aspect, in a possible design, the sensor is any one of a Hall sensor, an infrared sensor, a distance sensor, a pressure sensor, an optical proximity sensor, and an ambient light sensor.

In this application, the sensor may be any one of the Hall sensor, the infrared sensor, the distance sensor, the pressure sensor, the optical proximity sensor, and the ambient light sensor. In this way, detection of the physical connection between the external device and the electronic device is implemented, and because production costs are low, costs of an entire technical solution are reduced. Using the Hall sensor as an example, when a magnet enters a detection region of the Hall sensor, the Hall sensor is triggered to cause occurrence of the high-low level jump. In this application, the magnet is disposed in the external device, and the Hall sensor is disposed in the electronic device. It is determined, based on a distance between the magnet and the Hall sensor, for example, the magnet enters the detection region of the Hall sensor, and the distance between the magnet and the Hall sensor is less than the preset threshold, that the physical connection between the external device and the electronic device has been established. The Hall sensor is used as a sensor having low costs. In this solution, while detecting the physical connection, production costs are also controlled.

According to a second aspect, a combination apparatus of an electronic device and an external device is provided. The combination apparatus includes the electronic device and the external device.

The electronic device includes a processor, a sensor, and a pogo pin interface. The pogo pin interface includes a communication interface. The processor is configured to perform the method according to any items of the first aspect. The external device includes a processor and a pogo pin interface. The pogo pin interface includes a communication interface. When the electronic device is physically connected to the external device, a position of the pogo pin interface of the electronic device is aligned with a position of the pogo pin interface of the external device.

With reference to the second aspect, in a possible design, if the sensor of the electronic device is a Hall sensor, the external device further includes a first component. The first component is a magnet. When the electronic device is physically connected to the external device, the magnet is located in a detection region of the Hall sensor.

According to a third aspect, an electronic device is provided. The electronic device includes a memory, a sensor, a pogo pin interface, a display, and one or more processors. The memory, the sensor, the pogo pin interface, the display are coupled to the processor. The memory stores computer program code, the computer program code includes computer instructions. When the computer instructions are executed by the processor, the electronic device is enabled to perform the method according to any items of the first aspect.

According to a fourth aspect, a computer-readable storage medium is provided. The computer-readable storage medium stores instructions. When the instructions run on an electronic device, the electronic device is enabled to perform the method according to any items of the first aspect.

According to a fifth aspect, a computer program product including instructions is provided. When the instructions are run on an electronic device, the electronic device is enabled to perform the method according to any items of the first aspect.

According to a sixth aspect, an embodiment of this application provides a chip. The chip includes a processor. The processor is configured to invoke a computer program in a memory, to perform the method according to any items of the first aspect.

It may be understood that, for beneficial effects that can be achieved by the combination apparatus of an electronic device and an external device according to the second aspect, the electronic device according to the third aspect, the computer-readable storage medium according to the fourth aspect, and the computer program product according to the fifth aspect, the chip according to the sixth aspect, refer to the beneficial effects according to any one of the first aspect and the possible designs of the first aspect. Details are not described herein again.

### BRIEF DESCRIPTION OF DRAWINGS

FIG. 1 is a schematic diagram of an application environment of a pogo pin interface connection status detection method according to an embodiment of this application;
FIG. 2 is a schematic diagram of a structure of an electronic device according to an embodiment of this application;
FIG. 3 is a diagram of a software architecture of an electronic device according to an embodiment of this application;
FIG. 4 is a schematic diagram of a structure of an external device according to an embodiment of this application;
FIG. 5 is a schematic diagram of a connection between a tablet computer and a detachable keyboard according to an embodiment of this application;
FIG. 6 is a flowchart of an external device detection method according to an embodiment of this application;
FIG. 7 is a schematic diagram of a change of an output level of a Hall sensor of a tablet computer according to an embodiment of this application;
FIG. 8 is another schematic diagram of a change of an output level of a Hall sensor of a tablet computer according to an embodiment of this application;
FIG. 9 is another schematic diagram of a change of an output level of a Hall sensor of a tablet computer according to an embodiment of this application;
FIG. 10 is another schematic diagram of a change of an output level of a Hall sensor of a tablet computer according to an embodiment of this application;
FIG. 11 is a schematic diagram of changes of an output level of a Hall sensor and an output level of powering-up of a power interface in a tablet computer when a keyboard attaches to the tablet computer and normal communication is performed according to an embodiment of this application;
FIG. 12 is a schematic diagram of changes of an output level of a Hall sensor, an output level of a power interface, and an output level of a communication interface in a tablet computer when a keyboard attaches to the tablet computer and normal communication is performed according to an embodiment of this application;
FIG. 13 is a schematic diagram of displaying an icon of a keyboard on a display interface of a tablet computer according to an embodiment of this application;
FIG. 14 is a schematic diagram of displaying a prompt indicating that a communication interface is abnormal on a display interface of a tablet computer according to an embodiment of this application;
FIG. 15 is a schematic diagram of displaying another prompt indicating that a communication interface is abnormal on a display interface of a tablet computer according to an embodiment of this application;
FIG. 16 is a schematic diagram of displaying reconnection prompt information on a display interface of a tablet computer according to an embodiment of this application;
FIG. 17 is a flowchart of another external device detection method according to an embodiment of this application;
FIG. 18 is a schematic diagram of displaying connection prompt information on a display interface of a tablet computer according to an embodiment of this application;
FIG. 19 is a schematic diagram of stopping displaying an icon of a keyboard on a display interface of a tablet computer according to an embodiment of this application;
FIG. 20 is a schematic diagram of changes of an output level of a Hall sensor when the Hall sensor is triggered by mistake, an output level of a power interface, and an output level of a communication interface in a tablet computer according to an embodiment of this application;
FIG. 21 is a diagram of a module structure of an electronic device according to an embodiment of this application;
FIG. 22 is a diagram of a module structure of an external device according to an embodiment of this application; and
FIG. 23 is a diagram of a structure of a chip system according to an embodiment of this application.

### DESCRIPTION OF EMBODIMENTS

In descriptions of embodiments of this application, terms used in the following embodiments are only intended to describe particular embodiments, and are not intended to limit this application. As used in this specification and the appended claims of this application, a singular expression form, "a/an", "the", "foregoing", "said", and "this", are intended to also include an expression form of "one or more", unless clearly indicated to the contrary in the context. It should be further understood that, in the following embodiments of this application, "at least one" and "one or more" mean one or more than two (including two). The term "and/or" is used to describe an association relationship between associated objects, indicating that there are three types of relationships. For example, A and/or B may represent: only A exists, both A and B exist, and only B exists, where A and B may be singular or plural. The character "/" generally indicates an "or" relationship between the associated objects.

Reference to "one embodiment", "some embodiments", or the like described in this specification means that a specific feature, structure, or characteristic described in combination with this embodiment is included in one or more embodiments of this application. Therefore, statements such as "in one embodiment", "in some embodiments", "in some other embodiments", and "in some additional embodiments" in different places in this specification do not necessarily mean referring to a same embodiment. Instead, the statements mean "one or more but not all of embodiments", unless otherwise specifically emphasized in another manner. The terms "include", "contain", "have", and their variations mean "including but not limited to", unless otherwise specially emphasized in other ways. The term "connection" includes a direct connection and an indirect connection, unless otherwise specified. The terms "first" and "second" are used for descriptive purposes only and should not be construed as indicating or implying relative importance or implicitly indicating a quantity of technical features indicated.

In embodiments of this application, the term such as "example" or "for example" is used to represent giving an example, an illustration, or a description. Any embodiment or design scheme described as an "example" or "for example" in embodiments of this application should not be explained as being more preferred or having more advantages than another embodiment or design scheme. Exactly, use of the term, such as "example" or "for example", is intended to present a related concept in a specific manner.

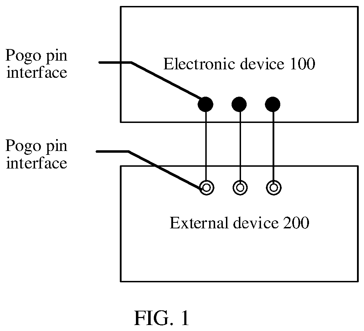

As functions of electronic devices such as a mobile phone, a tablet computer, and a notebook computer are upgraded, types of external devices connected through pogo pin interfaces also gradually increase. FIG. 1 is a schematic diagram of connecting an electronic device 100 and an external device 200 through a pogo pin interface. A communication connection may be implemented between the electronic device 100 and the external device 200 through the pogo pin interface. The pogo pin interface is a pogo pin interface.

The electronic device 100 involved in this application may be a device having a pogo pin interface, such as a mobile phone, a tablet computer, a projector, or a notebook computer. The external device involved in this application may be a device having a pogo pin interface, such as a keyboard, a hand-painted board, a sound box apparatus, a camera, a printer, an external display, or a scanner. Optionally, the external device may alternatively be a device having a pogo pin interface, such as an intelligent earphone, a watch, or a bracelet. The electronic device may be a device having a pogo pin interface, such as an earphone case providing a power supply for the external device, a watch charger, a bracelet charger, or a wireless charging apparatus.

A pogo pin is a spring-type probe formed by three basic parts, namely, a pin axis, a spring, and a pin barrel, through riveting and pre-pressing by a precise instrument. The probe implements power-on of devices or conduction of a circuit between the devices for communication. During actual production, a surface of the external device is provided with a pogo pin interface, and a surface of the electronic device is provided with a pogo pin interface. One is a male base, and the other is a female base. The pogo pin interface of the external device is connected to the pogo pin interface of the electronic device, to achieve effects of physical connection and communication connection between the external device and the electronic device by using a pogo pin. Usually, the pogo pin interface of the external device is a male base. The pogo pin interface of the electronic device is a female base.

Due to a structural design of the pogo pin, in a process of connecting the pogo pin interface of the external device and the pogo pin interface of the electronic device, positions of the pogo pin interface and the pogo pin interface may be offset due to movement of relative positions of the external device and the electronic device. Consequently, the external device is disconnected from the electronic device, and normal communication cannot be performed. For example, during a process of using the external device, a user moves the position of the external device, and the pogo pin interface of the external device is not aligned with the pogo pin interface of the electronic device. Consequently, the external device is disconnected from the electronic device, and normal communication cannot be performed. In this case, the user usually needs to determine, by using the external device, whether a disconnection occurs. The user cannot sense an actual status of the external device accurately and in a timely manner, causing poor use experience of the user.

An example in which the external device is a keyboard and the electronic device is a tablet computer is used for description. The keyboard is connected to a pogo pin interface of the tablet computer through a pogo pin interface, thereby implementing physical attachment between the keyboard and the tablet computer and a communication connection between the keyboard and the tablet computer. In a process in which the user uses the keyboard, if a position of the keyboard moves to cause the pogo pin interface of the keyboard to be offset relative to the pogo pin interface of the tablet computer, the keyboard cannot communicate with the tablet computer. The user can only determine, by using the keyboard, whether the keyboard is disconnected from the tablet computer. Consequently, the user cannot obtain an actual connection status of the keyboard in a timely manner, and use experience is poor.

In conventional technologies, an objective of monitoring a connection status of the external device is also implemented through communication between a processor of the electronic device and a processor of the external device. For example, a microcontroller unit (microcontroller unit, MCU) is disposed in the electronic device and the external device, and the electronic device detects, by using the MCU, whether a pogo pin interface has a signal loop, to determine whether the electronic device is connected to the external device. In this solution, the MCU needs to be disposed in the electronic device and the external device, and hardware costs are high. In addition, when the electronic device disconnects from the external device, it cannot be distinguished whether the user manually disconnects the connection or the external device accidentally disconnects from the electronic device. In other words, this solution also cannot enable the user to accurately sense an actual status of the external device.

An embodiment of this application provides an external device detection method. A matching sensing apparatus that is physically connected is disposed in the electronic device and the external device, so that a status of a physical connection between the external device and the electronic device can be determined by using the sensing apparatus that is physically connected. The status of a communication connection between the external device and the electronic device is determined based on communication data between the pogo pin interface of the electronic device and the pogo pin interface of the external device. An actual connection status of the external device may be continuously obtained based on the status of the physical connection and the status of the communication connection. In this way, the electronic device may prompt, by outputting prompt information or outputting audio information on a display, the user that the external device is connected or disconnected, so that the user can accurately sense the actual connection status of the external device in real time, thereby improving user experience.

A quantity of pogo pin interfaces of the electronic device 100 involved in this application is the same as a quantity of pogo pin interfaces of the external device 200. For example, the pogo pin interface of the electronic device and the pogo pin interface of the external device each may include a power interface, a ground interface, and at least one communication interface. Optionally, when there are a plurality of communication interfaces, functions of different communication interfaces in a communication process may be agreed on. It should be noted that, the electronic device and the external device in this application are companion devices. To be specific, the electronic device and the external device in this application have agreed on a communication protocol. In the communication protocol, a communication packet format, a transmission direction and transmission content of each communication interface, and the like are agreed on.

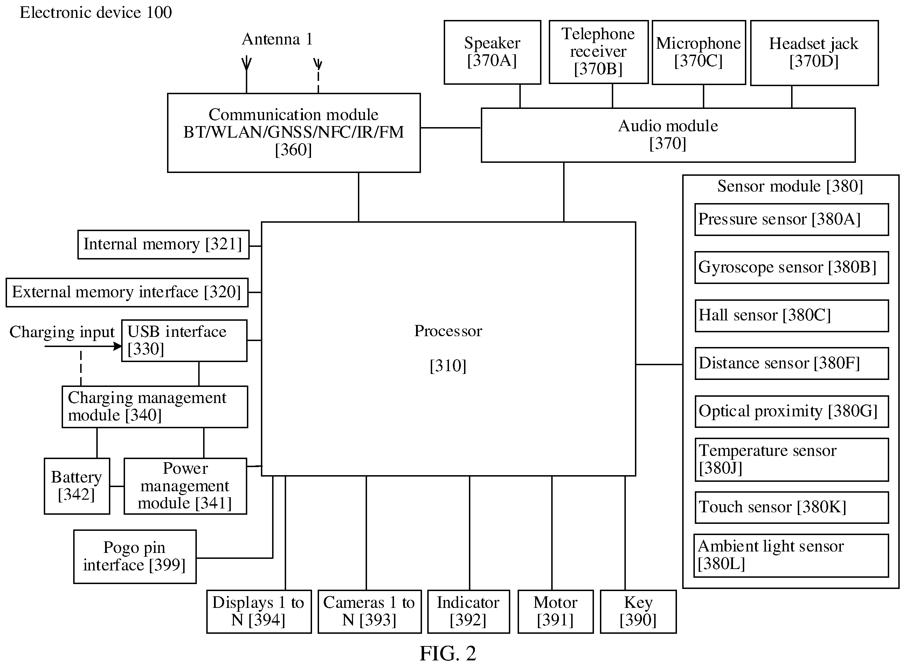

FIG. 2 is a block diagram of a structure of an electronic device (for example, an electronic device 100) according to an embodiment of this application. The electronic device 100 may include a processor 310, an external memory interface 320, an internal memory 321, a universal serial bus (universal serial bus, USB) interface 330, a charging management module 340, a power management module 341, a battery 342, an antenna 1, a communication module 360, an audio module 370, a speaker 370A, a telephone receiver 370B, a microphone 370C, a headset jack 370D, a sensor module 380, a key 390, a motor 391, an indicator 392, a camera 393, a display 394, and a pogo pin interface 399.

The sensor module 380 may include a pressure sensor 380A, a gyroscope sensor 380B, a barometric pressure sensor 380C, a magnetic sensor 380D, a distance sensor 380F, an optical proximity sensor 380G, a fingerprint sensor 380H, a temperature sensor 380J, and a touch sensor 380K, an ambient light sensor 380L, and the like.

The structure shown in this embodiment of the present invention does not constitute a specific limitation on the electronic device 100. The electronic device 100 may include more or fewer components than those shown in the figure, or some components may be combined, or some components may be divided, or different component arrangements may be used. The components shown in the figure may be implemented by using hardware, software, or a combination of software and hardware.

The processor 310 may include one or more processing units. For example, the processor 310 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, a neural-network processing unit (neural-network processing unit, NPU), and/or the like. Different processing units may be independent devices, or may be integrated into one or more processors.

The foregoing controller may be a decision-maker instructing components of the electronic device 100 to work in coordination according to an instruction, and may be a nerve center and a command center of the electronic device 100. The controller generates an operation control signal based on instruction operation code and a time-sequence signal, to control instruction fetching and instruction execution.

A memory may be further disposed in the processor 310, and is configured to store instructions and data. In some embodiments, the memory in the processor 310 may be a cache, and may store instructions or data that is recently used or cyclically used by the processor 310. If the processor 310 needs to use the instructions or the data again, the processor 310 may directly invoke the instructions or the data from the memory. Repeated access is avoided, and waiting time of the processor 310 is reduced, thereby improving system efficiency.

In some embodiments, the processor 310 may include an interface. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a USB interface, and/or the like.

An interface connection relationship between the modules illustrated in this embodiment of the present invention is merely an example for description, and does not constitute a limitation on the structure of the electronic device 100. The electronic device 100 may use an interface connection manner different from that in this embodiment of the present invention, or use a combination of a plurality of interface connection manners.

The charging management module 340 is configured to receive a charging input from a charger. The charger may be a wireless charger or a wired charger. In some embodiments of wired charging, the charging management module 340 may receive a charging input from the wired charger through the USB interface 330. In some embodiments of wireless charging, the charging management module 340 may receive a wireless charging input by using a wireless charging coil of the electronic device 100. When charging the battery 342, the charging management module 340 may further supply power to the electronic device 100 by using the power management module 341.

The power management module 341 is configured to connect to the battery 342, the charging management module 340, and the processor 310. The power management module 341 receives an input from the battery 342 and/or the charging management module 340, and supplies power to the processor 310, the internal memory 321, an external memory interface 320, the display 394, the camera 393, the communication module 360, and the like. The power management module 341 may be further configured to monitor parameters such as a battery capacity, a battery cycle count, and a battery health status (leakage or impedance). In some embodiments, the power management module 341 may alternatively be disposed in the processor 310. In some embodiments, the power management module 341 and the charging management module 340 may alternatively be disposed in a same device.

In this embodiment, the power management module 341 may further supply power to a power interface in the pogo pin interface 399. For example, when the processor determines that a physical connection between an external device and the electronic device has been established, the processor may control the power management module to supply power to the power interface in the pogo pin interface 399. When the processor determines that the physical connection between the external device and the electronic device has been disconnected, the processor may control the power management module to power down the power interface in the pogo pin interface 399.

A wireless communication function of the electronic device 100 may be implemented through the antenna 1, the communication module 360, a modem, the baseband processor, and the like.

The communication module 360 may be a communication processing module for providing a solution to wireless communication applied to the electronic device 100, for example, a wireless local area network (wireless local area networks, WLAN) (for example, a wireless fidelity (wireless fidelity, Wi-Fi) network), Bluetooth (blue tooth, BT), a global navigation satellite system (global navigation satellite system, GNSS), frequency modulation (frequency modulation, FM), near field communication (near field communication, NFC), and an infrared (infrared, IR) technology. The communication module 360 may be one or more devices integrating at least one communication processing module. The communication module 360 receives an electromagnetic wave via the antenna 1, performs frequency modulation and filtering processing on an electromagnetic wave signal, and sends a processed signal to the processor 310. The communication module 360 may further receive a to-be-sent signal from the processor 310, perform frequency modulation and amplification on the to-be-sent signal, and convert the signal into an electromagnetic wave via the antenna 1 for radiation.

In some embodiments, in the electronic device 100, the antenna 1 is coupled to the communication module 360, so that the electronic device 100 can communicate with a network and another device through a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), the BT, the GNSS, the WLAN, the NFC, the FM, the IR technology, and/or the like. The GNSS may include a global positioning system (satellite based augmentation systems, SBAS), a global navigation satellite system (global navigation satellite system, GLONASS), a BeiDou navigation satellite system (BeiDou navigation satellite system, BDS), a quasi-zenith satellite system (Quasi-Zenith satellite system, QZSS), and/or a satellite based augmentation system (satellite based augmentation systems, SBAS).

The electronic device 100 implements a display function through the GPU, the display 394, the application processor, and the like. The GPU is a microprocessor for image processing and is connected to the display 394 and the application processor. The GPU is configured to perform mathematical and geometric calculation for graphics rendering. The processor 310 may include one or more GPUs and execute program instructions to generate or change display information.

The display 394 is configured to display an image, a video, or the like. For example, the display 394 may display a real-time connection status of the external device. For example, a small icon of the keyboard is displayed in a status bar of the display, to represent that the external device (the keyboard) has been connected. In this embodiment of this application, when detecting that the keyboard has been connected, the electronic device 100 may display the small icon of the keyboard in the status bar of the display, or output, on a current display interface of the display, prompt information indicating that the keyboard has been connected. If it is detected that the keyboard is disconnected, the small icon of the keyboard displayed in the status bar of the display disappears, that is, the small icon of the keyboard is not displayed. If during a process of using the keyboard, it is detected that the keyboard is disconnected, a prompt pop-up window may further be output in a current interface displayed on the display, and content of the pop-up window prompts a user to adjust a position of the keyboard, so that a normal connection of the keyboard is restored. Optionally, the processor may further display abnormal communication interface information on the display when the processor detects that there is no data communication between the keyboard and the electronic device and determines that the communication interface is abnormal, to prompt the user to maintain the communication interface in a timely manner.

The display 394 includes a display panel. The display panel may be a liquid crystal display (liquid crystal display, LCD), an organic light-emitting diode (organic light-emitting diode, OLED), an active-matrix organic light-emitting diode (active-matrix organic light-emitting diode, AMOLED), a flex light-emitting diode (flex light-emitting diode, FLED), a Miniled, a MicroLed, a Micro-oLed, quantum dot light-emitting diodes (quantum dot light-emitting diodes, QLED), or the like. In some embodiments, the electronic device 100 may include 1 or N displays 394. N is a positive integer greater than 1.

The electronic device 100 may implement a photographing function by using the ISP, the camera 393, the video codec, the GPU, the display, the application processor, and the like.

The external memory interface 320 may be configured to connect to an external storage card such as a micro SD card, to expand a storage capacity of the electronic device 100. The external storage card communicates with the processor 310 by using the external memory interface 320, to implement a data storage function, for example, store files such as music and a video in the external storage card.

The internal memory 321 may be configured to store computer-executable program code. The executable program code includes instructions. The processor 310 runs the instructions stored in the internal memory 321, to perform various functional applications and data processing of the electronic device 100. The internal memory 321 may include a program storage region and a data storage region. The program storage region may store an operating system, an application required by at least one function (such as a voice playback function and an image playback function), and the like. The data storage region may store data (for example, audio data and an address book) and the like created when the electronic device 100 is used. In addition, the internal memory 321 may include a high-speed random access memory, or may include a nonvolatile memory such as at least one magnetic disk storage device, a flash memory device, or a universal flash storage (universal flash storage, UFS).

The electronic device 100 may implement an audio function such as music playback or recording through the audio module 370, the speaker 370A, the telephone receiver 370B, the microphone 370C, the headset jack 370D, the application processor, and the like, for example, implement a music playback function and a recording function.

The audio module 370 is configured to convert digital audio information into analog audio signal output, and is also configured to convert analog audio input into a digital audio signal. The audio module 370 may be further configured to encode and decode an audio signal. In some embodiments, the audio module 370 may be disposed in the processor 310, or some function modules in the audio module 370 may be disposed in the processor 310.

The speaker 370A, also referred to as a "horn", is configured to convert an audio electrical signal into a sound signal. The electronic device 100 may be used to listen to music or a hands-free call by using the speaker 370A.

The telephone receiver 370B, also referred to as a "handset", is configured to convert an audio electrical signal into a sound signal. When the electronic device 100 is configured to answer a call or receive voice information, the telephone receiver 370B may be put close to a human ear to answer a voice.

The microphone 370C, also referred to as a "mic" and a "mike", is configured to convert a sound signal into an audio electrical signal. When making a call or sending voice information, the user may place the microphone 370C close to a mouth of the user and make a sound, to input a sound signal into the microphone 370C. At least one microphone 370C may be disposed in the electronic device 100. In some embodiments, two microphones 370C may be arranged in the electronic device 100, to collect a sound signal and implement a noise reduction function. In some embodiments, three, four, or more microphones 370C may alternatively be disposed in the electronic device 100, to collect a sound signal, implement noise reduction, recognize a sound source, implement a directional recording function, and the like.

The headset jack 370D is configured to be connected to a wired headset. The headset jack 370D may be the USB interface 330, or may be a 3.5 mm open mobile terminal platform (open mobile terminal platform, OMTP) standard interface, or a cellular telecommunications industry association of the USA (cellular telecommunications industry association of the USA, CTIA) standard interface.

The pogo pin interface 399 is configured to establish a physical connection and a communication connection with the external device. The physical connection refers to an attached connection between the external device and a position of the electronic device. The communication connection refers to a data communication connection between the external device and the electronic device. The pogo pin interface includes a power interface, a ground interface, and at least one communication interface. The power interface is configured to provide a power supply to the external device when the electronic device determines to establish a physical connection with the external device. The at least one communication interface is configured to perform data transmission in a process of establishing a connection between the electronic device and the external device and after the connection is established. The electronic device and the external device follow a same communication protocol. For example, the electronic device and the external device follow a same public communication protocol. For example, the electronic device and the external device follow an agreed private communication protocol. In the communication protocol, a communication packet format, and a transmission direction and transmission content of each communication interface, and the like may be specified. For example, if there is only one communication interface, a communication protocol of the electronic device and the external device may agree on that the communication interface can transmit data in only one direction within a same time period. For example, when receiving communication data sent by the external device, the communication interface of the electronic device cannot send the communication data to the external device. When sending communication data to the electronic device, the communication interface of the external device cannot receive the communication data sent by the external device. Optionally, if there are two communication interfaces, a communication protocol of the electronic device and the external device may agree on that a communication manner of the communication interfaces is: a communication interface 1 of the electronic device is only configured to send communication data to the external device, and a communication interface 2 is only configured to receive communication data sent by the external device. Correspondingly, the communication interface 1 of the external device is only configured to receive communication data sent by the electronic device, and the communication interface 2 is only configured to send communication data to the electronic device. Alternatively, it is assumed that the communication interface 1 between the electronic device and the external device may be configured to receive and send communication data. The communication interface 2 between the electronic device and the external device is a standby interface. For example, in a normal case, the electronic device transmits data to the external device through the communication interface 1. When the electronic device cannot obtain communication data from the communication interface 1, the electronic device may send, to the external device, a request for transmitting data through the communication interface 2, so that the external device transmits communication data through the communication interface 2. Optionally, it may also be agreed that communication data types of the communication interface 1 and the communication interface 2 are different. For example, the communication interface 1 between the electronic device and the external device is configured to transmit normal communication data, and the communication interface 2 between the electronic device and the external device is configured to transmit test data. A function of a communication interface of the pogo pin interface may be agreed on in the communication protocol according to an actual use scenario.

The pressure sensor 380A is configured to sense a pressure signal and may convert the pressure signal into an electrical signal. In some embodiments, the pressure sensor 380A may be disposed on the display 394. There are many types of pressure sensors 380A, such as a resistive pressure sensor, an inductive pressure sensor, and a capacitive pressure sensor. The capacitive pressure sensor may include at least two parallel plates made of conductive material. When a force is applied to the pressure sensor, a capacitance between electrodes changes. The electronic device 100 determines pressure strength based on a capacitance change. When a touch operation is performed on the display 394, the electronic device 100 detects strength of the touch operation by using the pressure sensor 380A. The electronic device 100 may further calculate a touch position based on a detection signal of the pressure sensor 380A.

In some embodiments, the processor or an SOC of the electronic device may detect, by using the pressure sensor, whether the external device has established a physical connection with the electronic device. For example, if a pressure value obtained by the processor or the SOC of the electronic device by using the pressure sensor is less than a pressure threshold, it is determined that the external device has been connected and is in an in-place state. If the pressure value obtained by the processor or the SOC of the electronic device by using the pressure sensor is greater than the pressure threshold, it is determined that the external device has been disconnected and is in an out-of-place state. Optionally, when detecting, by using the pressure sensor, that the external device is connected, the processor or the SOC of the electronic device may further obtain a current pose of the electronic device in combination with the gyroscope sensor, to further determine a status of a physical connection between the electronic device and the external device.

The gyroscope sensor 380B may be configured to determine a motion pose of the electronic device 100. In some embodiments, angular velocities of the electronic device 100 around three axes (namely, an x axis, a y axis, and a z axis) may be determined by using the gyroscope sensor 380B. The gyroscope sensor 380B may be used for image stabilization during photographing. For example, when a shutter is opened, the gyroscope sensor 380B detects a shake angle of the electronic device 100, calculates, based on the angle, a distance that needs to be compensated by a lens module, and enables the lens to counteract the shake of the electronic device 100 by performing reverse motion, thereby implementing image stabilization. The gyroscope sensor 380B may be further used in scenarios such as navigation and a motion sensing game.

A Hall sensor 380C is a magnetic field sensor made according to a Hall effect. When a magnet enters a detection region of the Hall sensor, the Hall sensor is triggered, and an output level of the Hall sensor is interrupted. The Hall sensor may be configured to detect the status of the physical connection between the external device and the electronic device. In other words, the Hall sensor may measure a distance between the external device and the electronic device. Optionally, the electronic device may further include another magnetic field sensor.

In some embodiments, the Hall sensor is a magnetic field sensor made according to the Hall effect. When the magnetic field approaches or moves away from the detection region of the Hall sensor, a magnet triggers the magnetic field of the Hall sensor to change. The Hall sensor in the electronic device maintains an output level when the magnet is not detected in the detection region. For example, the output level of the Hall sensor is a low level when the magnet is not detected in the detection region. When a magnet enters the detection region of the Hall sensor, a magnetic field of the Hall sensor is triggered to change, and the output level of the Hall sensor also changes. For example, the output level of the Hall sensor may change from a low level to a high level. Alternatively, when the Hall sensor detects that the magnet approaches, an attachment interrupt is generated at the output level of the Hall sensor. When the magnet leaves the detection region of the Hall sensor, the magnetic field of the Hall sensor is triggered to change, and the output level of the Hall sensor also changes. For example, the output level of the Hall sensor may change from a high level to a low level. Alternatively, when the Hall sensor detects that the magnet leaves the detection region, an attachment interrupt is generated at the output level of the Hall sensor.

In some embodiments, when detecting that the output level of the Hall sensor changes from a low level to a high level, or detecting that an attachment interrupt is generated when the output level of the Hall sensor is a low level, the processor or the system on a chip (system on chip, SOC) of the electronic device 100 determines that the magnet enters the detection region of the Hall sensor. In other words, it is determined that the external device and the electronic device 100 are in a physical connection status, and the external device is in an in-place state. When detecting that the output level of the Hall sensor may change from a high level to a low level, or detecting that an attachment interrupt is generated when the output level of the Hall sensor is a high level, the processor or the SOC of the electronic device 100 determines that the magnet leaves the detection region of the Hall sensor. In other words, it is determined that the external device and the electronic device 100 are in a separated state, and the external device is in an out-of-place state.

The distance sensor 380F is configured to measure a distance. The electronic device 100 may measure the distance through infrared light or a laser.

In some embodiments, the processor or the SOC of the electronic device may detect, by using the distance sensor, whether the external device has established a physical connection with the electronic device. For example, if a distance value obtained by the processor or the SOC of the electronic device by using an infrared sensor is less than a first distance threshold, it is determined that the external device has been connected and is in an in-place state. If the distance value obtained by the processor or the SOC of the electronic device by using the infrared sensor is greater than a second distance threshold, it is determined that the external device has been disconnected and is in an out-of-place state. Optionally, when detecting, by using the distance sensor, that the external device is connected, the processor or the SOC of the electronic device may further obtain a current pose of the electronic device in combination with the gyroscope sensor, to further determine a status of a physical connection between the electronic device and the external device.

The optical proximity sensor 380G may include, for example, a light-emitting diode (LED) and a light detector such as a photodiode. The light-emitting diode may be an infrared light-emitting diode. Infrared light may be emitted outward through the light-emitting diode. Infrared reflected light from a nearby object is detected by using the photodiode. When sufficient reflected light is detected, it may be determined that there is an object near the electronic device 100. When insufficient reflected light is detected, it may be determined that there is no object near the electronic device 100. The electronic device 100 may detect, by using the optical proximity sensor 380G, that the user holds the electronic device 100 close to the ear for a call, to automatically turn off the display to save power. The optical proximity sensor 380G may be further used for automatic unlocking or locking in a carrying case mode and a pocket mode.

The ambient light sensor 380L is configured to sense ambient light brightness. The electronic device 100 may adaptively adjust brightness of the display based on the sensed brightness of the ambient light brightness. The ambient light sensor 380L may be further configured to automatically adjust white balance during photographing. The ambient light sensor 380L may further cooperate with the optical proximity sensor 380G to detect whether the electronic device 100 is in a pocket, to prevent an accidental touch.

In some embodiments, the processor or the SOC of the electronic device may detect, by using the ambient light sensor, whether the external device has established a physical connection with the electronic device. For example, if a brightness value obtained by the processor or the SOC of the electronic device by using the ambient light sensor is less than a brightness threshold, it is determined that the external device has been connected and is in an in-place state. If the brightness value obtained by the processor or the SOC of the electronic device by using the infrared sensor is greater than the brightness threshold, it is determined that the external device has been disconnected and is in an out-of-place state. Optionally, when detecting, by using the ambient light sensor, that the external device is connected, the processor or the SOC of the electronic device may further obtain a current pose of the electronic device in combination with the gyroscope sensor, to further determine a status of a physical connection between the electronic device and the external device.

The temperature sensor 380J is configured to detect a temperature. The electronic device 100 executes a temperature processing policy based on the temperature detected by the temperature sensor 380J. For example, when the temperature reported by the temperature sensor 380J exceeds a threshold, the electronic device 100 reduces performance of a processor located near the temperature sensor 380J, to reduce power consumption and implement heat protection.

The touch sensor 380K is also referred to as a "touch panel", and may be arranged in the display 394. The touch sensor is configured to detect a touch operation performed on or near the touch sensor. The touch sensor may transfer a detected touch operation to the application processor, to determine a touch event type and provide a corresponding visual output by using the display 394.

The key 390 includes a power-on key, a volume key, and the like. The key 390 may be a mechanical key, or a touch key. The electronic device 100 receives an input of the key 390, and generates a key signal input related to user setting and function control of the electronic device 100.

The motor 391 may generate a vibration prompt. The motor 391 may be configured to provide an incoming call vibration prompt and a touch vibration feedback. For example, the motor 391 may correspond to different vibration feedback effects for touch operations on different applications (such as photographing and audio playback). The motor 391 may also correspond to different vibration feedback effects for touch operations applied to different regions of the display 394. Different application scenarios (such as time reminding, receiving information, an alarm clock, and a game) can also correspond to different vibration feedback effects. A touch vibration feedback effect may be further customized.

The indicator 392 may be an indicator lamp, and may be configured to indicate a charging status and a power change, or may be configured to indicate a message, a missed call, a notification, or the like.

A software system of the electronic device 100 may use a layered architecture, an event-driven architecture, a micro core architecture, a micro service architecture, or a cloud architecture. In this embodiment of the present invention, an Android system with a layered architecture is used as an example to describe a software structure of the electronic device 100.

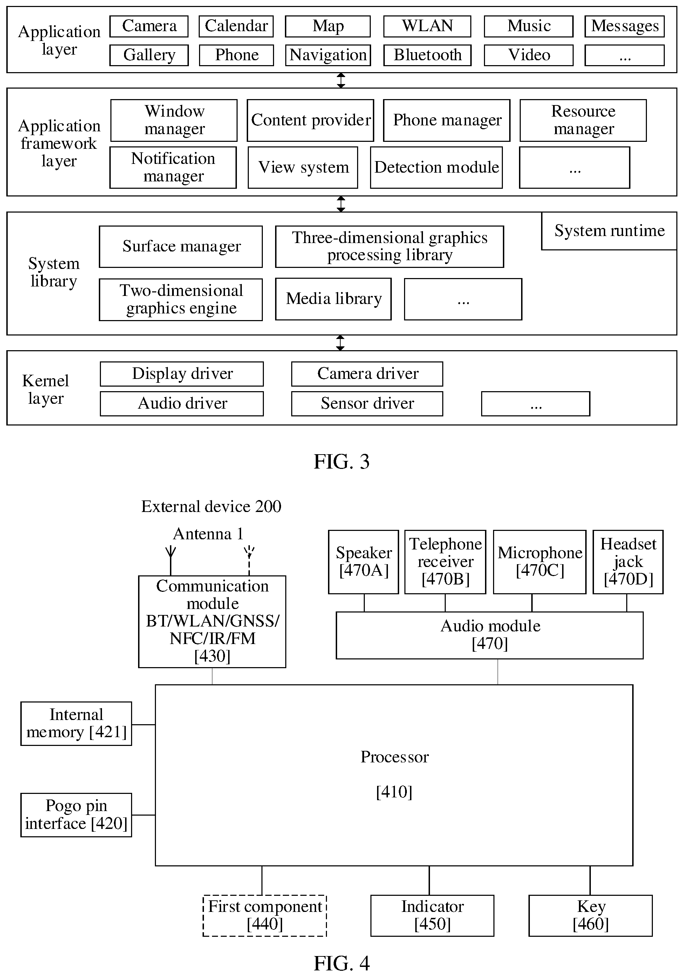

FIG. 3 is a block diagram of a software structure of an operating system of an electronic device 100 according to an embodiment of the present invention. In the layered architecture, software is divided into several layers, and each layer has a clear role and task. The layers are in communication with each other through software interfaces. In some embodiments, the operating system is divided into four layers from top to bottom: an application layer, an application framework layer, a system runtime and a system library, and a kernel layer.

The application layer may include a series of application packages.

As shown in FIG. 3, the application packages may include applications such as Camera, Gallery, Calendar, Phone, Map, Navigation, WLAN, Bluetooth, Music, Video, and Messages.

The application framework layer provides an application programming interface (application programming interface, API) and a programming framework for the applications at the application layer. The application framework layer includes some predefined functions.

As shown in FIG. 3, the application framework layer may include a detection module, a window manager, a content provider, a view system, a phone manager, a resource manager, and a notification manager.

In some embodiments, the detection module is configured to perform real-time continuous detection on a connection status of an external device. When detecting that the external device establishes a connection with an electronic device, the detection module outputs, on a display interface of the electronic device by using the view system, information indicating the connection, and displays an icon of the external device in a status bar of the display interface. When detecting that the external device is disconnected from the electronic device, the detection module outputs reconnection information and the like on the display interface of the electronic device by using the view system. When detecting that a communication interface is abnormal, the detection module may output, on the display interface of the electronic device by using the view system, information indicating that the communication interface is abnormal, and the like.

The window manager is configured to manage a window program. The window manager may obtain a size of a display, determine whether there is a status bar, perform screen locking, perform screen capturing, and so on. The content provider is configured to store and obtain data, and enable the data to be accessible by an application. The data may include a video, an image, audio, a phone call made and answered, a browsing history, favorites, a phone book, and the like. The view system includes a visual control, for example, a control for displaying text or a control for displaying a picture. The view system may be configured to construct an application. A display interface may include one or more views.

The phone manager is configured to provide a communication function for the electronic device 100, for example, call status management (including call connection, hang-up, and the like). The resource manager provides various resources, such as localized character strings, icons, pictures, layout files, and video files, for applications. The notification manager enables an application to display notification information in a status bar, and may be used to convey an informative message that may automatically disappear after a short period of time without user interaction. For example, the notification manager is used for informing completion of downloading, for message alerts, and so on. The notification manager may alternatively provide, on a status bar at the top of the system, a notification in a form of a chart or scroll bar text, for example, a notification of an application running in the background, or provide, on a screen, a notification in a form of a dialog window. For example, text information is displayed in the status bar, an alert sound is produced, the electronic device vibrates, and an indicator light blinks.

The system runtime includes a kernel library and a virtual machine. The system runtime is responsible for scheduling and managing the operating system. The kernel library includes two parts: one part is a functional function that java language needs to invoke, and the other part is a kernel library of the operating system.

The application layer and the application framework layer are run in the virtual machine. The virtual machine executes java files of the application layer and the application framework layer as binary files. The virtual machine is configured to perform functions, such as object lifecycle management, stack management, thread management, security and anomaly management, and garbage collection.

The system library may include a plurality of function modules, for example, a surface manager (surface manager), a media library (media libraries), a three-dimensional graphics processing library (for example, openGL ES), and a 2D graphics engine (for example, an SGL).

The surface manager is configured to manage a display subsystem and provide fusion of 2D and 3D layers for a plurality of applications. The media library supports playback and recording in a plurality of commonly used audio and video formats, and static image files. The media library may support a plurality of audio and video encoding formats, for example, MPEG 4, H.264, MP3, AAC, AMR, JPG, and PNG. The three-dimensional graphics processing library is configured to implement three-dimensional graphics drawing, image rendering, composition, layer processing, and the like. The 2D graphics engine is a drawing engine for 2D drawing.

The kernel layer is a layer between hardware and software. The kernel layer includes at least a display driver, a camera driver, an audio driver, and a sensor driver.

In some embodiments, a description is provided by using that a sensor is a Hall sensor. When a magnet enters a detection region of the Hall sensor, the Hall sensor is triggered, and the sensor driver transmits an output level of the Hall sensor to a detection module. The detection module controls, based on a change of the output level of the Hall sensor, a power interface to be powered up or powered down. In addition, the detection module determines a status of a connection between the external device and the electronic device based on the change of the output level of the Hall sensor and a detected change of an output level of the communication interface, and displays corresponding content on the display interface of the display by controlling the display driver. For example, when determining that the electronic device establishes a communication connection with the external device, the detection module displays an icon of a keyboard on the display interface of the display by controlling the display driver. When determining that the communication connection between the electronic device and the external device is disconnected, the detection module stops displaying the icon of the keyboard and the like on the display interface of the display by controlling the display driver.

FIG. 4 is a block diagram of a structure of an external device (for example, an external device 200) according to an embodiment of this application. The external device 200 may include a processor 410, a pogo pin interface 420, a communication module 430, an indicator 450, a key 460, an audio module 470, a speaker 470A, a telephone receiver 470B, a microphone 470C, a headset jack 470D, and the like.

The structure shown in this embodiment of the present invention does not constitute a specific limitation on the external device 200. The external device 200 may include more or fewer components than those shown in the figure, or some components may be combined, or some components may be divided, or different component arrangements may be used. The components shown in the figure may be implemented by using hardware, software, or a combination of software and hardware.

The processor 410 may include one or more processing units. For example, the processor 410 may include an application processor AP, a microcontroller unit (microcontroller unit, MCU), a modem processor, a controller, a memory, a video codec, a digital signal processor DSP, a baseband processor, and/or the like. Different processing units may be independent devices, or may be integrated into one or more processors.

The controller may be a decision-maker instructing components of the external device 200 to work in coordination according to an instruction, and may be a nerve center and a command center of the external device 200. The controller generates an operation control signal based on instruction operation code and a time-sequence signal, to control instruction fetching and instruction execution.

A memory may be further disposed in the processor 410, and is configured to store instructions and data. In some embodiments, the memory in the processor 410 may be a cache, and may store instructions or data that is recently used or cyclically used by the processor 410. If the processor 410 needs to use the instructions or the data again, the processor 410 may directly invoke the instructions or the data from the memory. Repeated access is avoided, and waiting time of the processor 410 is reduced, thereby improving system efficiency.

In some embodiments, the processor 410 may include an interface. The interface may include an integrated circuit I2C interface, an integrated circuit built-in audio I2S interface, a pulse code modulation PCM interface, a universal asynchronous receiver/transmitter UART interface, a mobile industry processor interface MIPI, a general purpose input/output GPIO interface, a USB interface, and/or the like.

An interface connection relationship between the modules illustrated in this embodiment of the present invention is merely an example for description, and does not constitute a limitation on the structure of the external device 200. The external device 200 may use an interface connection manner different from that in this embodiment of the present invention, or use a combination of a plurality of interface connection manners.

The internal memory 421 may be configured to store computer-executable program code. The executable program code includes instructions. The processor 410 runs the instructions stored in the internal memory 421, to perform various functional applications and data processing of the external device 200. The internal memory 421 may include a program storage region and a data storage region. The program storage region may store an operating system, an application required by at least one function (such as a voice playback function and an image playback function), and the like. The data storage region may store data (for example, audio data and a phone book) and the like created when the external device 200 is used. In addition, the internal memory 421 may include a high-speed random access memory, or may include a nonvolatile memory such as at least one magnetic disk storage device, a flash memory device, or a universal flash storage (universal flash storage, UFS).

A wireless communication function of the external device 200 may be implemented through an antenna 1, the communication module 430, the baseband processor, and the like.

The communication module 430 may be a communication processing module for providing a solution to a wireless communication applied to the communication module 360, for example, a wireless local area network WLAN (for example, a Wi-Fi network), a Bluetooth BT, a global navigation satellite system GNSS, a frequency modulation FM, a near field communication NFC, and an infrared IR technology. The communication module 430 may be one or more devices integrating at least one communication processing module. The communication module 430 receives an electromagnetic wave via the antenna 1, performs frequency modulation and filtering processing on an electromagnetic wave signal, and sends a processed signal to the processor 410. The communication module 430 may further receive a to-be-sent signal from the processor 410, perform frequency modulation and amplification on the to-be-sent signal, and convert the signal into an electromagnetic wave via the antenna 1 for radiation.

The electronic device 100 may implement audio functions, such as alert sound playback by using the audio module 470, the speaker 470A, the telephone receiver 470B, the microphone 470C, the headset jack 470D, the application processor, and the like.

The audio module 470 is configured to convert digital audio information into an analog audio signal for output, and is further configured to convert an analog audio input into a digital audio signal. The audio module 470 may be further configured to encode and decode an audio signal. In some embodiments, the audio module 470 may be disposed in the processor 410, or some function modules in the audio module 470 may be disposed in the processor 410.

The speaker 470A, also referred to as a "horn", is configured to convert an audio electrical signal into a sound signal. The external device 200 may play the alert sound by using the speaker 470A. In some embodiments, if the external device establishes a communication connection with the electronic device, after the external device 200 receives a communication connection establishment signal sent by the electronic device 100, the processor 410 may control the speaker 470A to output a "beep" alert sound, to prompt a user that a connection to the electronic device is established.

The telephone receiver 470B, also referred to as a "handset", is configured to convert an audio electrical signal into a sound signal.

The microphone 470C, also referred to as a "mic" and a "mike", is configured to convert a sound signal into an audio electrical signal. Two microphones 470C may be arranged in the external device 200, to collect a sound signal and implement a noise reduction function. In some embodiments, three, four, or more microphones 470C may alternatively be disposed in the electronic device 100, to collect a sound signal, implement noise reduction, recognize a sound source, implement a directional recording function, and the like.

The headset jack 470D is configured to be connected to a wired headset. The headset jack 470D may be a USB interface, or may be a 3.5 mm open mobile terminal platform OMTP standard interface, or a cellular telecommunications industry association of the USA CTIA standard interface.

The pogo pin interface 420 is configured to establish a physical connection and a communication connection with the electronic device 100. The pogo pin interface includes a power interface, a ground interface, and at least one communication interface. A power interface is configured to provide a power supply to the external device when a physical connection is established with the electronic device. The at least one communication interface is configured to perform data transmission in a process of establishing a connection between the electronic device and the external device and after the connection is established. The electronic device agrees on a communication protocol with the external device. In the communication protocol, a communication packet format, a transmission direction and transmission content of each communication interface, and the like may be agreed on. For example, if there is only one communication interface, a communication protocol of the electronic device and the external device may agree on that the communication interface can transmit data in only one direction within a same time period. For example, when receiving communication data sent by the external device, the communication interface of the electronic device cannot send the communication data to the external device. When sending communication data to the electronic device, the communication interface of the external device cannot receive the communication data sent by the external device. Optionally, if there are two communication interfaces, a communication protocol of the electronic device and the external device may agree on that a communication manner of the communication interfaces is: a communication interface 1 of the electronic device is only configured to send communication data to the external device, and a communication interface 2 is only configured to receive communication data sent by the external device. Correspondingly, a communication interface 1 of the external device is only configured to receive communication data sent by the electronic device, and a communication interface 2 is only configured to send communication data to the electronic device. Alternatively, it is assumed that the communication interface 1 between the electronic device and the external device may be configured to receive and send communication data. The communication interface 2 between the electronic device and the external device is a standby interface. For example, in a normal case, the electronic device transmits data to the external device through the communication interface 1. When the electronic device cannot obtain communication data from the communication interface 1, the electronic device may send, to the external device, a request for transmitting data through the communication interface 2, so that the external device transmits communication data through the communication interface 2. Optionally, it may also be agreed that communication data types of the communication interface 1 and the communication interface 2 are different. For example, the communication interface 1 between the electronic device and the external device is configured to transmit normal communication data, and the communication interface 2 between the electronic device and the external device is configured to transmit test data. A function of the communication interface may be agreed on in the communication protocol according to an actual use scenario.

A position of a pogo pin interface of the electronic device 100 has a correspondence with a position of a pogo pin interface of the external device 200. When the electronic device 100 attaches to the external device 200, a pogo pin female base of the electronic device 100 correspondingly attaches to the pogo pin male base of the external device 200. A specific position of the pogo pin interface in the electronic device is not limited in this embodiment.

Optionally, when a sensor of the electronic device 100 is a Hall sensor or another magnetic sensor, the external device 200 includes a first component 440.

The first component 440 is a component matching a sensor in the electronic device 100. The electronic device 100 may detect an in-place state of the external device 200 based on the sensor and the first component. For example, if the sensor in the electronic device 100 is a Hall sensor, the first component 440 of the external device 200 may be a magnet. When the external device establishes a physical connection with the electronic device, the magnet enters or leaves a detection region of the Hall sensor, triggering an output level of the Hall sensor to change. The electronic device 100 determines a connection status of the external device based on a change of the level.

In some embodiments, the sensor in the electronic device 100 and the first component in the external device 200 form a matching sensing apparatus that is physically connected to the electronic device and that is in the external device.

A position of the sensor of the electronic device 100 has a correspondence with a position of the first component 440 of the external device 200. Positions of the sensor of the electronic device 100 and the first component 440 of the external device 200 are not limited in this embodiment.

The indicator 450 may be an indicator light, and may be configured to indicate a charging status or a power change, or may be configured to indicate a message, a notification, and the like.

When the external device is a keyboard, the key 460 include keyboard keys and the like. The key 460 may be a mechanical key, or a touch key. The external device 200 receives an input of the key 460, and generates a key signal input related to data input and functional control of the electronic device 100.

Through attachment between an existing electronic device and the external device, the pogo pin interface of the electronic device attaches to the pogo pin interface of the external device, so that communication between the electronic device and the external device is implemented. If a position of the pogo pin interface of the electronic device is offset from a position of the pogo pin interface of the external device, the pogo pin interface cannot perform communication due to the offset of the pogo pin interface, in other words, even if the external device still attaches to the electronic device, the electronic device is disconnected from the external device.

In the pogo pin interface connection status detection method provided in this application, a sensor is disposed on the electronic device, and a component corresponding to the sensor is disposed on the external device, to detect a status of a physical connection between the electronic device and the external device. When the electronic device is disconnected from the external device through communication, the status of the physical connection between the electronic device and the external device may be further determined. Optionally, when it is determined, by using the sensor, that the physical connection between the electronic device and the external device is normal, detection of the communication connection between the electronic device and the external device may also be implemented. In combination with the status of the physical connection between the electronic device and the external device, a status of a connection (a status of a communication connection) between the pogo pin interface of the electronic device and the pogo pin interface of the external device is detected, so that an obtained detection result is more accurate. In the conventional technologies, this resolves a problem that cannot be distinguished whether a communication connection is disconnected due to disconnection of the physical connection between the electronic device and the external device, or whether only a communication connection is disconnected between the electronic device and the external device. Interference to a communication connection status detection result caused by disconnection of the physical connection between the electronic device and the external device.

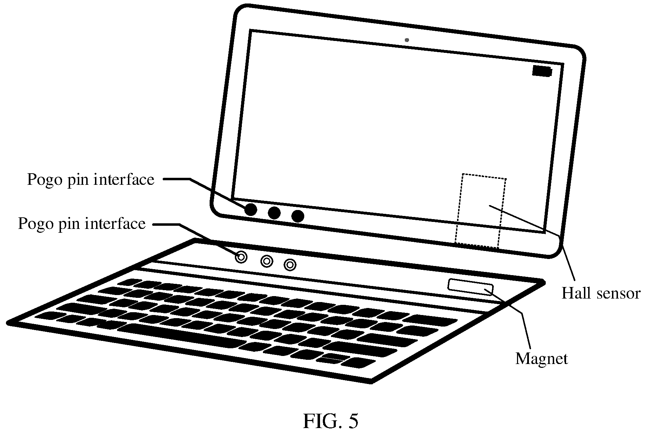

The pogo pin interface connection status detection method provided in this application may be applied to FIG. 5. FIG. 5 provides an example of an electronic device and an external device. In FIG. 5, the electronic device is a tablet computer, and the external device is a detachable keyboard (a keyboard for short in the following embodiments). The tablet computer and the detachable keyboard are both provided with three pogo pin interfaces. The three pogo pin interfaces include a power interface, a ground interface, and a communication interface. In FIG. 5, a sensor that is disposed in the tablet computer and that is configured to detect a physical position connection is a Hall sensor, and correspondingly, a component that is disposed in the keyboard and that is configured to detect the physical position connection is a magnet. In FIG. 5, a position of a pogo pin interface of the tablet computer corresponds to a position of a pogo pin interface of the keyboard. When the tablet computer normally attaches to the keyboard, the position of the pogo pin interface of the tablet computer is in an aligned state with the position of the pogo pin interface of the keyboard. In FIG. 5, the pogo pin interface of the tablet computer and the pogo pin interface of the keyboard are correspondingly disposed on a left side of a device. The Hall sensor in the tablet computer corresponds to a position of the magnet of the keyboard. When the tablet computer normally attaches to the keyboard, the magnet of the keyboard is located in a detection region of the Hall sensor of the tablet computer. In FIG. 5, the Hall sensor and the magnet of the keyboard in the tablet computer are correspondingly disposed on a right side of the device. When the pogo pin interface of the tablet computer attaches to the pogo pin interface of the keyboard, the magnet of the keyboard enters the detection region of the Hall sensor of the tablet computer, triggering an output level of the Hall sensor to change. An SOC of the tablet computer monitors that the output level of the Hall sensor changes. The SOC controls the power interface to be powered up, and sends a command to the keyboard through the communication interface. If the SOC receives a response from the keyboard, it is determined that a communication connection has been established between the keyboard and the tablet computer. If during a keyboard connection process, when a command is sent by the SOC to the keyboard, a corresponding response does not be obtained, and the SOC determines that the output level of the Hall sensor does not change, in other words, the keyboard is not removed by a user from the tablet computer, communication cannot be performed because the position of the pogo pin interface is offset. In this case, the electronic device sends prompt information, to prompt the user to reconnect the keyboard, to restore the connection. In an example, the reminding information is output on a display interface of a display.

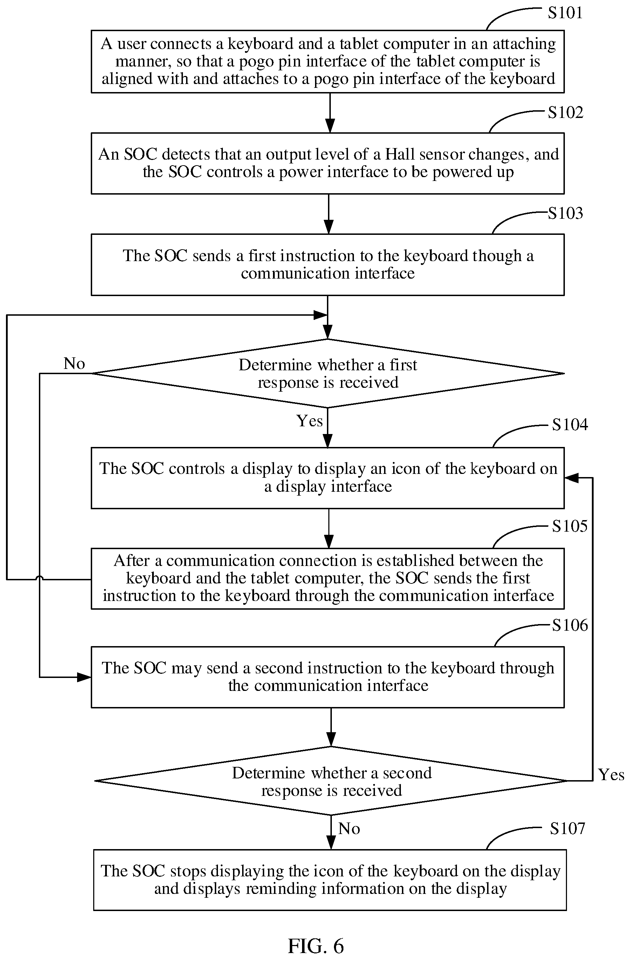

With reference to the example given in FIG. 5, the SOC of the electronic device in this embodiment is an execution entity of an external device detection method. An external device detection method is provided. Refer to FIG. 6. The method includes the following steps.

S101: A pogo pin interface of a tablet computer is aligned with and attaches to a pogo pin interface of a keyboard.

In some embodiments, the keyboard may be a magnetic keyboard. A user connects the keyboard and the tablet computer, and may place the tablet computer in a magnetic slot of the keyboard, to implement magnetic attachment between the tablet computer and the keyboard. Optionally, the pogo pin interface of the keyboard may be disposed in the magnetic slot, and the pogo pin interface of the tablet computer may be disposed on a surface attaching to the magnetic slot of the keyboard. When the magnetic slot of the keyboard where the tablet computer placed on is in an attached state, the pogo pin interface of the tablet computer and the pogo pin interface of the keyboard are in an attachment and alignment state.

When the tablet computer and the keyboard are in an attached and connected state, the magnet in the keyboard enters a detection region of a Hall sensor of the tablet computer, and the magnet approaches the Hall sensor, so that an output level of the Hall sensor changes. An SOC of the tablet computer monitors the output level of the Hall sensor, to determine whether the keyboard is attached and connected to the tablet computer.

S102: The SOC detects that the output level of the Hall sensor changes, and the SOC controls a power interface to be powered up.

In some embodiments, the Hall sensor in the tablet computer may maintain an output level before the Hall sensor is triggered by the magnet. For example, the output level of the Hall sensor is kept at a low level before the Hall sensor is triggered by the magnet. Alternatively, the output level of the Hall sensor is kept at a high level before the Hall sensor is triggered by the magnet. The SOC may obtain the output level of the Hall sensor by using a sensor driver based on a specific detection frequency. For example, the SOC may continuously monitor the output level of the Hall sensor by using a sensor driver. Alternatively, the SOC may obtain and record the output level of the Hall sensor every one second by using the sensor driver. Therefore, the SOC may compare a currently obtained output level with a historically obtained output level, to determine whether the output level of the Hall sensor changes within a period of time.

In this embodiment, the user connects the keyboard and the tablet computer in an attaching manner, and after the tablet computer is physically connected to the keyboard through the pogo pin interface, a distance between the magnet of the keyboard and the Hall sensor of the tablet computer is less than a preset threshold. The tablet computer detects, by using the Hall sensor, that the magnet enters the detection region of the Hall sensor, the Hall sensor is triggered, and the output level of the Hall sensor changes.

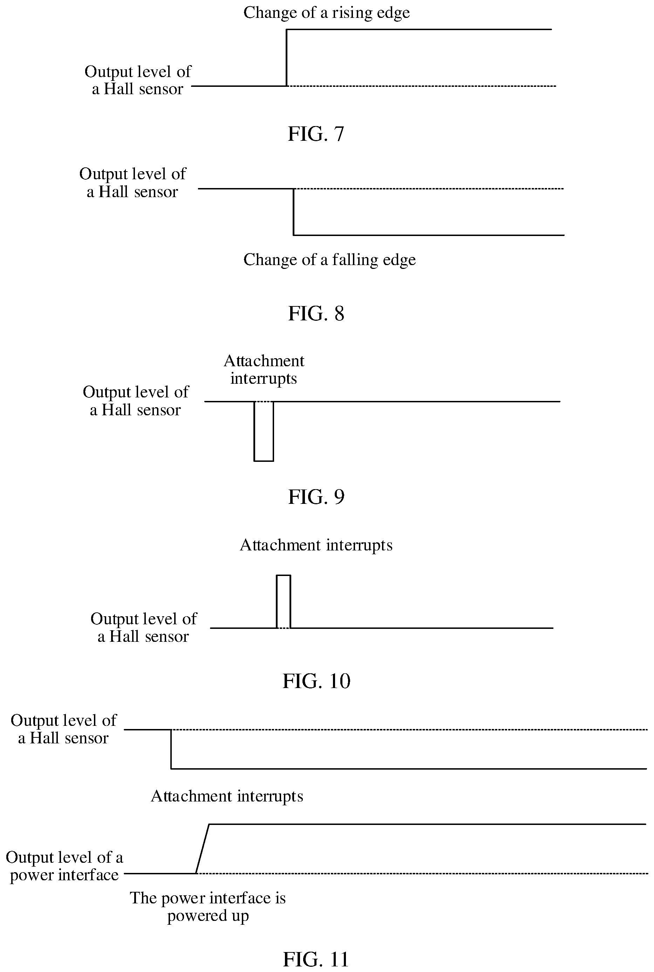

In a possible implementation, for example, as shown in FIG. 7, before the Hall sensor is triggered, the output level of the Hall sensor is a low level. When the keyboard attaches to the tablet computer, the Hall sensor detects the magnet in the detection region, and the output level of the Hall sensor becomes a high level. In this case, the SOC may determine, based on an output level of the Hall sensor obtained within a period of time, whether a level changes from low to high. If the output level of the Hall sensor changes from the low level to the high level, the SOC controls a power interface of the tablet computer to be powered up.

In a possible implementation, for example, as shown in FIG. 8, before the Hall sensor is triggered, the output level of the Hall sensor is a high level. When the keyboard attaches to the tablet computer, the Hall sensor detects the magnet in the detection region, and the output level of the Hall sensor becomes a low level. In this case, the SOC may determine, based on an output level of the Hall sensor obtained within a period of time, whether a level changes from high to low. If the output level of the Hall sensor changes from the high level to the low level, the SOC controls a power interface of the tablet computer to be powered up.

In a possible implementation, for example, as shown in FIG. 9, before the Hall sensor is triggered, the output level of the Hall sensor is a high level. When the keyboard attaches to the tablet computer, the Hall sensor detects the magnet in the detection region, and an attachment interrupt with a low level is generated at the output level of the Hall sensor. In this case, the SOC may determine, based on an output level of the Hall sensor obtained within a period of time, whether there is an attachment interrupt. If the SOC detects that the output level of the Hall sensor within a period of time is a high level, the attachment interrupt is generated, and the SOC controls a power interface of the tablet computer to be powered up.

In a possible implementation, for example, as shown in FIG. 10, before the Hall sensor is triggered, the output level of the Hall sensor is a low level. When the keyboard attaches to the tablet computer, the Hall sensor detects the magnet in the detection region, and an attachment interrupt at a high level is generated at the output level of the Hall sensor. In this case, the SOC may determine, based on an output level of the Hall sensor obtained within a period of time, whether there is an attachment interrupt. If the SOC detects that the output level of the Hall sensor within a period of time is a low level, the attachment interrupt is generated, and the SOC controls a power interface of the tablet computer to be powered up. Optionally, a range of the detection region of the Hall sensor is determined based on a delivery parameter of the sensor.

In some embodiments, when determining that the Hall sensor is triggered by the magnet, that is, determining that the keyboard attaches to the tablet computer, the SOC controls the power interface of the tablet computer to be powered up. For an output level of the power interface, refer to FIG. 11. An initial output level of the Hall sensor is a high level. When the magnet of the keyboard approaches the Hall sensor of the tablet computer, the magnet enters the detection region of the Hall sensor, an attachment interrupt is triggered to be generated at the output level of the Hall sensor, and the output level of the Hall sensor changes from the high level to a low level. After detecting that the output level of the Hall sensor changes, the SOC controls the power interface to be powered up, and the output level of the power interface changes from an un-powered-up state (a low level) to a powered-up state (a high level). In other words, if a problem occurs in the power interface, or the tablet computer cannot normally supply power to the power interface, after the Hall sensor is triggered by the magnet, a signal of the power interface is still at a low level. The SOC may alternatively determine, based on the output level of the power interface, whether the power interface is abnormal. If the power interface is abnormal, the SOC may further prompt, by outputting information about the anomaly of the power interface on a display interface, the user to maintain the power interface in a timely manner.

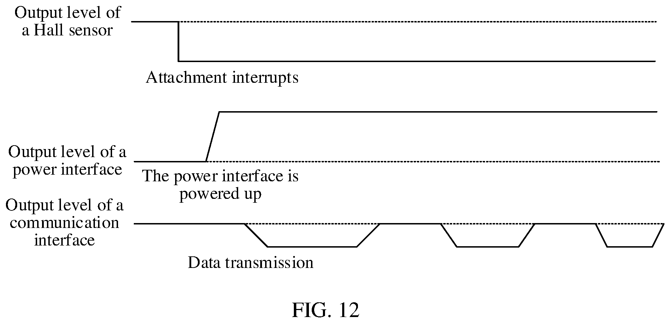

Optionally, in some embodiments, after the SOC detects that the output level of the Hall sensor changes from a high level to a low level and controls the power interface to be powered up, communication data is transmitted through a communication interface of the tablet computer when a communication connection is established between the pogo pin interface of the keyboard and the pogo pin interface of the tablet computer, and an output level of the communication interface changes with the communication data transmission. Refer to FIG. 12. A communication connection is established between the keyboard and the tablet computer. When the communication connection is normal, a communication instruction is transmitted between the keyboard and the tablet computer through a communication interface, and an output level of the communication interface generates regular changes conforming to an agreement of a communication protocol. Optionally, a change of the output level of the communication interface indicates that data transmission is performed between communication interfaces. If transmitted data is abnormal, a change rule of the output level of the communication interface does not conform to a change rule agreed on by the communication protocol. In view of this, when the output level of the communication interface changes, the SOC may further check whether the transmitted data is abnormal. If the SOC determines that the transmitted data is abnormal, in other words, the change rule of the level does not conform the agreement of the communication protocol, it may consider that the communication connection of the communication interface is abnormal. The communication instruction carries communication data. A format of the communication data between the keyboard and the tablet computer may be agreed on in the communication protocol.

S103: The SOC sends a first instruction to the keyboard through the communication interface. If receiving a first response, the SOC determines that a communication connection is established with the keyboard, and S104 is performed. If the SOC does not receive the first response within first duration, S106 is performed.

The first instruction is for testing whether the communication connection between the tablet computer and the keyboard is normal. Optionally, the first instruction may be a test instruction, the test instruction may carry test data, and a data format of the test data and a data format of the communication data may be the same.

In some embodiments, when the keyboard is normally connected to the tablet computer, the SOC may send the first instruction to the keyboard at a first periodicity. The first periodicity may be a long periodicity. For example, the first periodicity may be 10 seconds or 15 seconds. The first instruction may be a polling instruction in a normal connection.

In some embodiments, the first instruction may be a test instruction. A data format of the test instruction and a data format of the communication instruction may be the same or different. It may be agreed that a bit of the data format is a test flag bit. If a value of the test flag bit is a first value, the command is the test instruction. If the value of the test flag bit is a second value, the command is the communication instruction. The first value may be 0, and the second value may be 1. This is not limited. The data format of the test instruction and the data format of the communication instruction may alternatively be different. For example, the test instruction is 32-bit data, and the communication instruction is 64-bit data. After the communication protocol is agreed, the external device may identify, based on an agreed data format, whether a currently received instruction is the test instruction or the communication instruction. The data format of the test instruction and the data format of the communication instruction are not limited in this embodiment. A test flag bit, after receiving the test instruction, the keyboard reads the test flag bit by analyzing the test instruction, and returns a test response corresponding to the test instruction to the tablet computer. If the SOC does not receive, within a preset time period, the test response returned by the keyboard, it indicates that the communication connection is not established between the keyboard and the tablet computer. In consideration of processing time of the keyboard, it is assumed that the test response returned by the keyboard is received within the preset time period. If the communication connection is normal, the test response returned by the keyboard needs to be completed within a short time period. For example, the preset time period may be 30 milliseconds.

Alternatively, in some embodiments, the first instruction may be a communication instruction. When a communication connection is normal, after receiving the communication instruction, the keyboard returns a corresponding communication response to the tablet computer based on communication data carried in the communication instruction. The communication response carries response data corresponding to the communication data. If the SOC receives the communication response within a preset time period, it is determined that the communication connection is established with the keyboard. If the SOC does not receive the communication response within the preset time period, or the SOC receives a response returned by the keyboard within the preset time period, and the response does not carry response data corresponding to the communication data, it is determined that the communication connection is not established between the keyboard and the tablet computer.

Optionally, if the tablet computer includes one communication interface, the SOC sends the first instruction through the communication interface. If the tablet computer includes a plurality of communication interfaces, the SOC may send the first instruction through one or more communication interfaces according to the agreement of the communication protocol.

In some embodiments, if the pogo pin interface of the keyboard and the pogo pin interface of the tablet computer each have only one communication interface 1, in this case, the SOC sends the first instruction to the keyboard through the communication interface 1. If the SOC receives, through the communication interface 1, the first response returned by the keyboard, the communication interface 1 of the keyboard and the communication interface 1 of the tablet computer are normal, and a communication connection is established between the keyboard and the tablet computer. If the SOC does not receive, within the preset time period, the first response returned by the keyboard, it is determined that at least one of the communication interface 1 of the keyboard and the communication interface 1 of the tablet computer is abnormal, and a communication connection is not established between the keyboard and the tablet computer.

In some embodiments, the pogo pin interface of the keyboard and the pogo pin interface of the tablet computer each include two communication interfaces. It is agreed in a communication protocol that communication interfaces 1 are main communication interfaces. For example, the communication interface 1 of the keyboard is responsible for receiving or sending communication data and test data between the tablet computer and the keyboard. Communication interfaces 2 are standby interfaces. For example, when the keyboard cannot transmit data through the communication interface 1, the communication interface 2 may be switched to to transmit the data. In this case, the SOC sends the first instruction to the communication interface 1 of the keyboard through the communication interface 1. During normal communication, the keyboard receives the first instruction through the communication interface 1, and returns, through the communication interface 1, the first response corresponding to the first instruction to the communication interface 1 of the tablet computer. If the keyboard receives the first instruction through the communication interface 1, but cannot transmit the first response through the communication interface 1, the keyboard switches the communication interface 1 to the communication interface 2 to return the first response. In other words, the keyboard returns, through the communication interface 2, the first response to the communication interface 2 of the tablet computer. If the SOC receives the first response through the communication interface 1, it is determined that the communication interface 1 of the keyboard is normal, and the communication connection between the keyboard and the tablet computer is normal. If the SOC receives the first response not through the communication interface 1 and receives the first response through the communication interface 2, it is determined that the communication interface 1 of the keyboard is abnormal, and the communication interface 2 of the keyboard is normal. Optionally, when the communication interface 1 is abnormal and the communication interface 2 is normal, the tablet computer may switch the communication interface 1 to the communication interface 2 to perform subsequent data transmission. If the SOC does not receive the first response returned through any one of the communication interfaces within the preset time period, it is determined that a communication connection is not established between the keyboard and the tablet computer.

In some embodiments, if the SOC receives the first response returned by the keyboard, it is determined that a communication connection has been established between the tablet computer and the keyboard. In this case, the SOC may control a display of the tablet computer, and output, to the user on a display interface, related prompt information indicating that a communication connection has been established between the tablet computer and the keyboard, that is, S105 is performed. If the SOC does not receive the first response returned by the keyboard, it is determined that a communication connection is not established between the tablet computer and the keyboard. In this case, the SOC may further determine whether not receiving the first response of the keyboard is an accidental event, and the SOC may send a second instruction to the keyboard for a plurality of times, to further determine whether a communication connection is not established between the tablet level and the keyboard, that is, S106 is performed.

S104: The SOC controls the display to display an icon of the keyboard on the display interface.

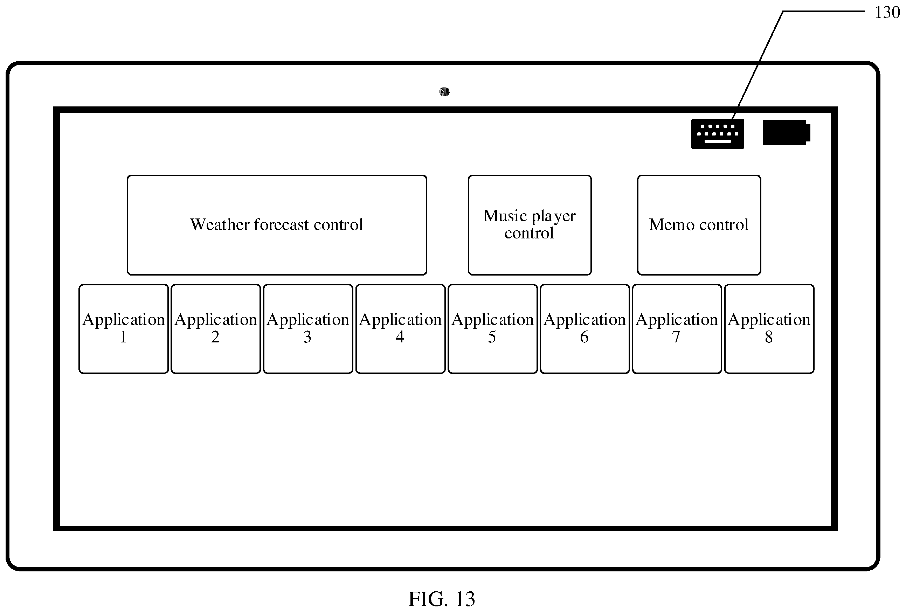

In some embodiments, the SOC determines that a communication connection has been established between the tablet computer and the keyboard. In this case, the SOC may output, on the display interface by controlling the display of the tablet computer, related prompt information indicating that a communication connection has been established between the tablet computer and the keyboard. For example, the SOC may display, on a main interface of the tablet computer, related prompt information indicating that a communication connection has been established between the tablet computer and the keyboard. Refer to FIG. 13. The SOC displays a small icon 130 of the keyboard on a status bar of the main interface of the display, indicating that a communication connection has been established between the tablet computer and the keyboard. The main interface includes a plurality of application icons and a plurality of function controls. The status bar further includes a battery level icon of the tablet computer.

S105: After the communication connection is established between the keyboard and the tablet computer, the SOC sends the first instruction to the keyboard through the communication interface, and performs a corresponding operation based on whether the keyboard returns the corresponding first response.

In some embodiments, the SOC determines, based on S101 to 104, that the communication connection is established between the keyboard and the tablet computer. After the communication connection is established between the keyboard and the tablet computer, the SOC may perform polling on a status of the communication connection of the keyboard at a first periodicity, to detect the status of the communication connection between the keyboard and the tablet computer in a timely manner. The SOC herein may send the first instruction to the keyboard at the first periodicity, and continuously detect the status of the connection between the keyboard and the tablet computer in real time. It should be noted that, when a physical connection and the communication connection between the keyboard and the tablet computer are normal, the SOC periodically sends the first instruction to the keyboard. This is polling when the communication connection is normal, a polling periodicity does not need to be excessively frequent, and the first periodicity is a long periodicity. For example, the first periodicity may be 10 seconds, 15 seconds, or the like. For example, test frequency is sending the first instruction to the keyboard every 10 seconds or every 15 seconds, to avoid power consumption caused by frequently sending a test instruction by the SOC, and also avoid normal communication between the keyboard and the tablet computer being affected due to frequency sending of the first instruction. The first instruction may be a test instruction. If the SOC receives a first response that is returned by the keyboard based on the test instruction, it is determined that a communication connection between the keyboard and the tablet computer is normal. If the SOC does not receive, within the first duration, the first response returned by the keyboard, it is determined that the communication connection is not established between the keyboard and the tablet computer. For the method for determining the status of the communication connection between the keyboard and the tablet computer based on whether the keyboard returns the corresponding first response, refer to S104.

S106: The SOC sends the second instruction to the keyboard through the communication interface. If a second response is received, S104 is performed. If the second response is not received within second duration, S107 is performed.

In this embodiment, the SOC does not receive, within the preset time period, the second response returned by the keyboard. In this case, the SOC may send the second instruction to the keyboard through the communication interface at a second periodicity. Optionally, the tablet computer may alternatively send a communication instruction to the keyboard. The first instruction may be the same as or different from the second instruction. The second duration in S1015 may be the same as the first duration in S106, and the second duration and the first duration are determined based on an actual instruction receiving/sending rate.

The first periodicity in this embodiment is different from the first periodicity in S105. The first periodicity in the foregoing S105 means polling when the SOC determines that the communication connection between the keyboard and the tablet computer is normal. The second periodicity in this embodiment means an anomaly test when the SOC determines that the communication connection between the keyboard and the tablet computer is abnormal. The SOC needs to determine, within a short time period, whether a communication connection is established between the keyboard and the tablet computer. In view of this, the second periodicity in this embodiment is a short periodicity. For example, the second periodicity may be 20 milliseconds, 30 milliseconds, or the like. Optionally, to further avoid an accidental case in which the SOC does not receive a test response of the keyboard, the SOC may send the second instruction for a plurality of times within the second periodicity, to determine whether the communication connection between the keyboard and the tablet computer is normal. For example, the SOC may continuously send the second instruction to the keyboard for three times within a periodicity of 30 milliseconds, and determine, based on whether the keyboard returns the second response, whether a communication connection is established between the keyboard and the tablet computer.

If the SOC receives the second response at least once that is returned by the keyboard through the communication interface, it is determined that the communication interface of the tablet computer attaches to the communication interface of the keyboard, the tablet computer and the keyboard are in a normal communication state, and the SOC may implement data transmission through the communication interface. In this case, the SOC performs S104, to be specific, controls the display to display the icon of the keyboard on the display interface. If the SOC does not receive, for a plurality of consecutive times, the second response returned by the keyboard, it is determined that a communication connection is not established between the tablet computer and the keyboard, and the SOC performs S107. At least one of the communication interface of the tablet computer and the communication interface of the keyboard is in an abnormal state, and the SOC cannot transmit data through the communication interface.

In some embodiments, when the tablet computer and the keyboard each have only one communication interface, the SOC sends the second instruction by default through the communication interface, and if the SOC does not receive the second response that is returned by the keyboard through the communication interface, it is determined that the communication interfaces of the tablet computer and the keyboard are abnormal, and a communication connection is not established between the keyboard and the tablet computer.

In some embodiments, if the tablet computer and the keyboard each include two communication interfaces, it may be agreed in a communication protocol that communication data is transmitted through communication interfaces 1, and test data is transmitted through communication interfaces 2. The SOC sends, through the communication interface 2, the second instruction to the communication interface 2 of the keyboard. If the second response returned by the keyboard is not received, the SOC determines that the communication interfaces 2 of the tablet computer and the keyboard are abnormal, and a communication connection is not established between the keyboard and the tablet computer.

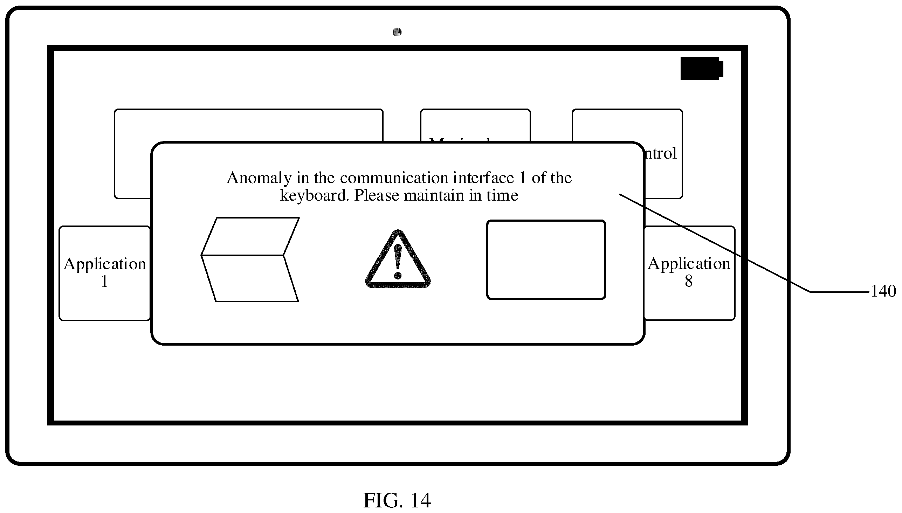

In some embodiments, the tablet computer and the keyboard each include two communication interfaces, and both the two communication interfaces may receive and send data. For example, a communication interface 1 of the keyboard is responsible for receiving or sending communication data and test data between the tablet computer and the keyboard, and a communication interface 2 is a standby interface. The communication protocol agrees that data transmission is performed between a communication interface 1 of the tablet computer and the corresponding communication interface 1 of the keyboard by default, and when the data transmission cannot be performed through the communication interface 1, another communication interface may be switched to to perform data transmission. In this case, when the SOC sends the second instruction through the communication interface 1, during normal communication, the keyboard receives the second instruction through the communication interface 1, and returns, through the communication interface 1, a test response corresponding to the second instruction to the communication interface 1 of the tablet computer. If the keyboard receives the test instruction through the communication interface 1, but cannot transmit the second response through the communication interface 1, the keyboard switches the communication interface 1 to the communication interface 2 to return the second response. In other words, the keyboard returns, through the communication interface 2, the second response to the communication interface 2 of the tablet computer. If the SOC receives the second response through the communication interface 1, it is determined that the communication interface 1 of the keyboard is normal, and the communication connection between the keyboard and the tablet computer is normal. If the SOC receives the second response not through the communication interface 1 and receives the second response through the communication interface 2, it is determined that the communication interface 1 of the keyboard is abnormal, the communication interface 2 of the keyboard is normal, and the communication connection between the keyboard and the tablet computer is normal. Optionally, the SOC may output anomaly information 140 of the communication interface 1 of the keyboard to the user, and further position an abnormal communication interface, so that the user can maintain the abnormal communication interface in a timely manner. Refer to FIG. 14.

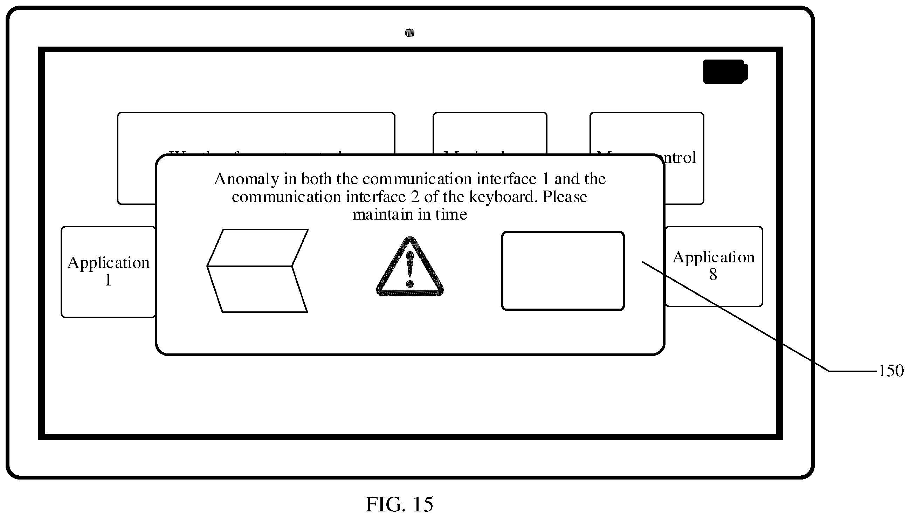

If the SOC does not receive, for a plurality of consecutive times, the second response returned by the keyboard, the SOC determines, based on an agreement of the communication protocol, that both the communication interface 1 and the communication interface 2 of the keyboard have an anomaly, and a communication connection is not established between the keyboard and the tablet computer. The anomaly may be caused because the keyboard is in poor contact with the tablet computer, to be specific, the communication interface of the keyboard and the communication interface of the tablet computer are not in an aligned position. Alternatively, a hardware anomaly may exist between the communication interface 1 and the communication interface 2 of the keyboard. Optionally, when determining that the hardware anomaly exists in the communication interface 1 and the communication interface 2 of the keyboard, the SOC may further output information 150 about an abnormal communication interface on the display, to prompt the user to maintain the abnormal communication interface in a timely manner. Refer to FIG. 15.

S107: The SOC stops displaying the icon of the keyboard on the display and displays reminding information on the display.

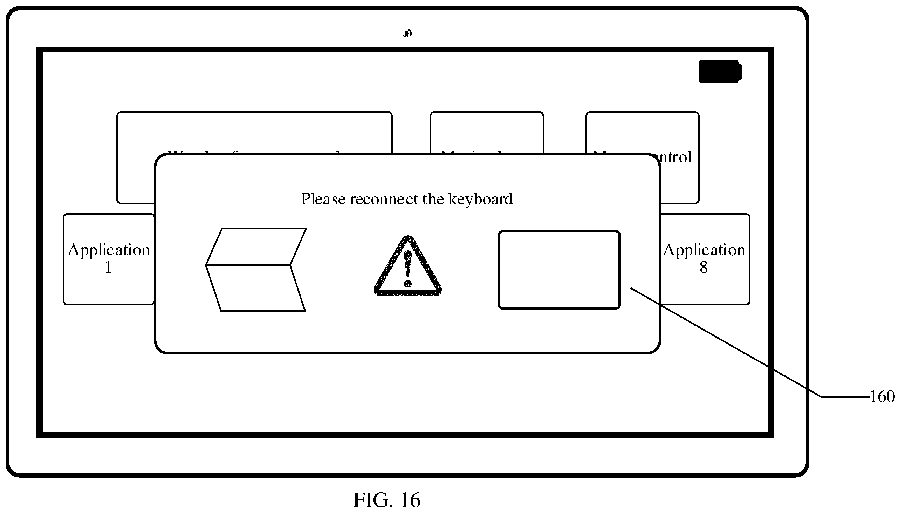

If the SOC continuously sends the second instruction to the keyboard within the second periodicity, but does not receive the second responses returned by the keyboard, it is determined that a communication connection is not established between the keyboard and the tablet computer, and the SOC may stop displaying the icon of the keyboard on the display. Optionally, the SOC may further display, on the display, prompt information for prompting the user that a communication connection is not established between the keyboard and the tablet computer. Alternatively, the SOC may play, through a voice, prompt information for prompting the user that a communication connection is not established between the keyboard and the tablet computer. Correspondingly, to avoid an anomaly caused by that the communication interface of the keyboard and the communication interface of the tablet computer are not in an aligned position, the SOC may further output, on a current display interface of the display, reminding information 160 for prompting the user to reconnect the keyboard. For example, refer to FIG. 16. The SOC displays, in a pop-up window of the current display interface (a main interface) of the display, the reminding information 160 prompting the user to reconnect the keyboard.

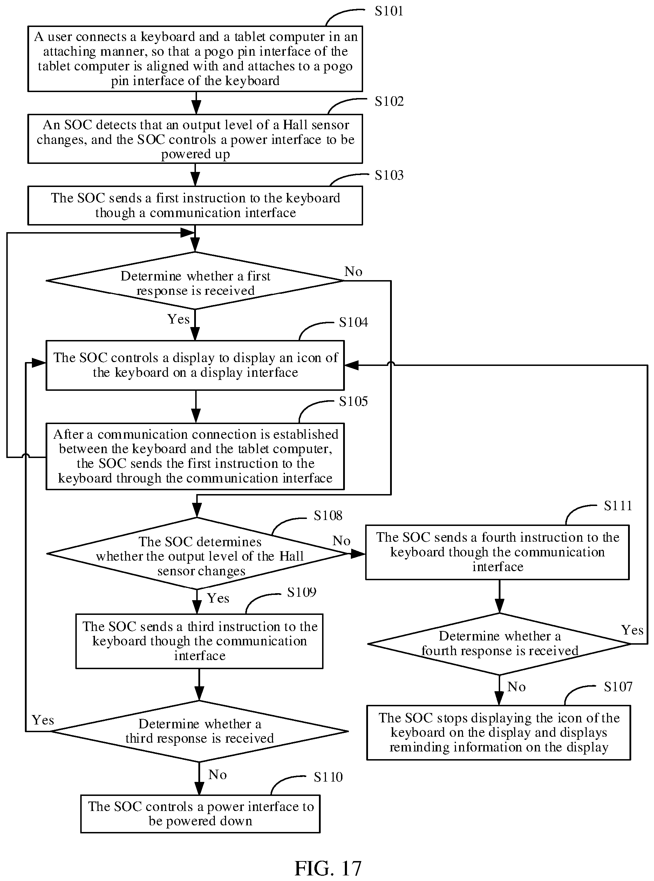

In some embodiments, after the SOC of the tablet computer does not receive the first response returned by the keyboard, in other words, after the SOC determines that a communication connection is not established between the tablet computer and the keyboard, the SOC may further determine, by detecting the output level of the Hall sensor, whether the physical connection between the tablet computer and the keyboard is disconnected, to provide accuracy of keyboard detection. For example, if the magnet leaves the detection region of the Hall sensor, and the output level of the Hall sensor changes, it is determined that the physical connection between the tablet computer and the keyboard is disconnected. There may be a case in which the user manually removes the keyboard. For example, if the magnet is always in the detection region of the Hall sensor, and the output level of the Hall sensor does not change, it is determined that the physical connection between the tablet computer and the keyboard is normal. The communication interface of the keyboard may not be aligned with the communication interface of the tablet computer. As a result, a communication connection between the tablet computer and the keyboard is not established. Refer to FIG. 17. When the foregoing S101 to S103 are performed, if the first response returned by the keyboard is not received by the SOC, the SOC performs S108, specifically including:
S108: The SOC determines whether the output level of the Hall sensor changes. If the output level of the Hall sensor changes, S109 is performed. If the output level of the Hall sensor does not change, S111 is performed.

In some embodiments, if the SOC does not receive the first response returned by the keyboard, the SOC may further determine whether the keyboard is manually removed, in other words, the keyboard is completely disconnected from the tablet computer, or the keyboard is disconnected from the tablet computer due to a relative position offset.

In this embodiment, the SOC may obtain a signal state of the output level of the Hall sensor within preset duration. Refer to the method for determining the output level of the Hall sensor described in S102. If the SOC determines that the output level of the Hall sensor changes within latest preset duration recently, for example, FIG. 8 is used as an example, after the Hall sensor is triggered by the magnet, the output level changes from an initial high level to a low level, and within the latest preset duration, for example, within one minute before a current time point, the output level of the Hall sensor changes from a low level to a high level and always keeps at the high level, it indicates that the magnet leaves the detection region of the Hall sensor, and consequently, the output level of the Hall sensor changes. In other words, currently, the keyboard is physically separated from the tablet computer, and the magnet of the keyboard is not in the detection region of the Hall sensor of the tablet computer. In this case, to further determine whether the keyboard is completely disconnected from the tablet computer, the SOC performs S109, and then sends a third instruction to the keyboard to perform a response test.

Optionally, a case in which the SOC determines that the output level of the Hall sensor changes within the latest preset duration may alternatively be a case in which when the keyboard and the tablet computer are connected for the first time in a latest period of time, to be specific, after the tablet computer is separated from the keyboard for a period of time, and when the tablet computer is connected to the keyboard again, the magnet enters the detection region of the Hall sensor, the output level of the Hall sensor of the tablet computer is triggered to change, and the output level of the Hall sensor changes from a high level to a low level. However, when the keyboard is physically connected to the tablet computer, the communication interfaces may not be aligned. As a result, the SOC does not receive the first response from the keyboard. In this case, the SOC also needs to perform S109, and then sends the third instruction to the keyboard to perform the response test.

Still using FIG. 7 as an example, after the Hall sensor is triggered by the magnet, the output level changes from the initial high level to the low level. Within the preset duration, for example, within 30 seconds before a current time point, the output level of the Hall sensor is always the low level. The SOC determines that currently, the keyboard always attaches to the tablet computer, and the magnet of the keyboard is still in the detection region of the Hall sensor of the tablet computer. In this case, the SOC performs S111, and then sends a fourth instruction to the keyboard to perform a response test. The fourth instruction herein may be the same as the second instruction.

It should be noted that, a result of sending the fourth instruction to the keyboard by the SOC to perform a test in S111 is different from that of sending the third instruction to the keyboard by the SOC to perform a test in S109. Instruction content of the fourth instruction and instruction content of the third instruction may be the same.

S109: The SOC sends the third instruction to the keyboard through the communication interface. If a third response is received, S104 is performed. If the third response is not received within third duration, the SOC performs S110, to control the power interface to be powered down.

In this embodiment, the SOC determines that the output level of the Hall sensor changes. In this case, the SOC may send the third instruction to the keyboard at a third periodicity. The third instruction herein is a query in an abnormal case. To determine a status of a connection between the keyboard and the tablet computer as soon as possible, the third periodicity is a short periodicity. For example, the third periodicity may be 20 milliseconds, 30 milliseconds, or the like. For example, the third instruction is continuously sent for three times within 30 milliseconds, and the third instruction is sent for a plurality of times within the third periodicity, to avoid an accidental case in which the third response is not received at all. Optionally, the third instruction may be the same as the second instruction, the third instruction may be a test instruction, or the third instruction may be a communication instruction.

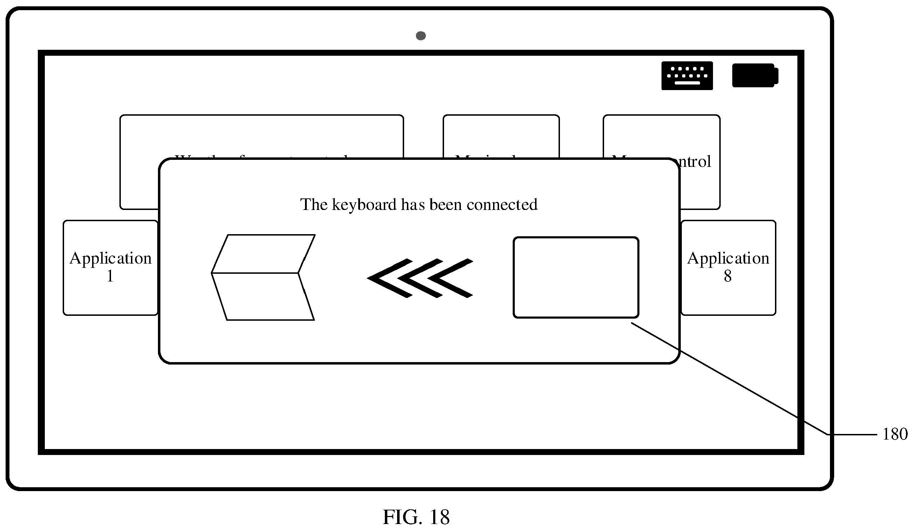

In this embodiment, the SOC determines that the output level of the Hall sensor changes within a latest preset time period. If the SOC receives the third response returned by the keyboard within the third duration, a case in which the tablet computer is connected to the keyboard for the first time after a complete disconnection may exist. The complete disconnection means that the keyboard is manually separated from the tablet computer, so that the keyboard and the tablet computer are disconnected from each other in terms of a physical position and a communication connection. In this case, the SOC performs S104, to control the display to display a small icon of the keyboard in the status bar of the display interface. In addition, the SOC may further display, on the current interface (the main interface) of the display, information that a communication connection has been established between the tablet computer and the keyboard. For example, refer to FIG. 18. The SOC displays, in the current interface of the display in a form of a pop-up window, prompt information 180 indicating that the keyboard is connected. The prompt information may further include an icon for indicating that the tablet computer is connected to the keyboard, so that the user can learn more intuitively that a communication connection has been established between the tablet computer and the keyboard.

In some embodiments, the SOC determines that the output level of the Hall sensor changes within the latest preset time period. If the SOC does not receive, within the third duration, the third response returned by the keyboard, it indicates that the keyboard is completely disconnected from the tablet computer. The third duration may be determined based on an actual instruction receiving/sending rate.

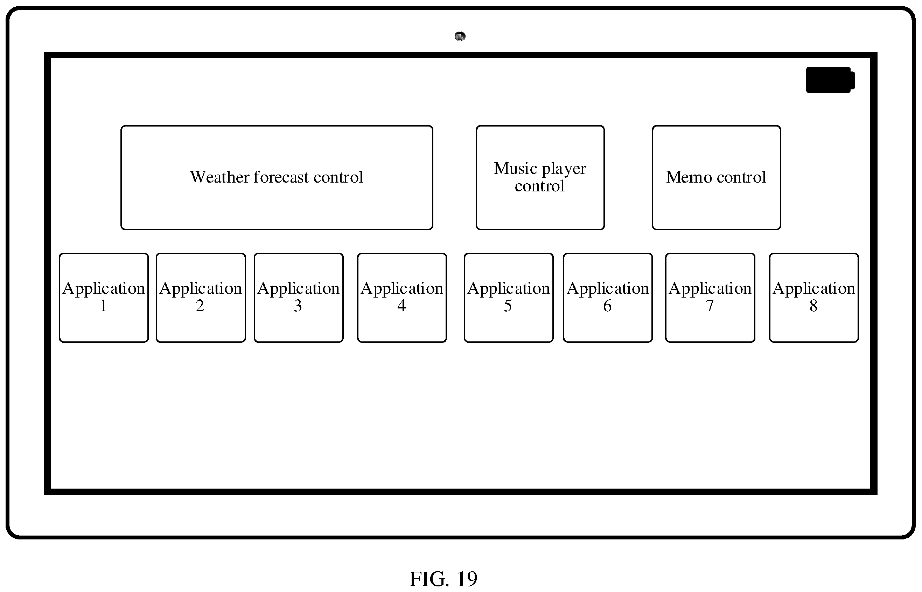

There may be two cases. In one case, for example, the magnet may leave the detection region of the Hall sensor, in other words, the user manually disconnects the keyboard from the tablet computer, the physical connection and the communication connection between the keyboard and the tablet computer are disconnected. In this case, the SOC controls the display to stop displaying the small icon of the keyboard in the status bar of the display, to indicate that the keyboard is disconnected from the tablet computer, and there is no available external keyboard on the tablet computer currently. Refer to FIG. 19.

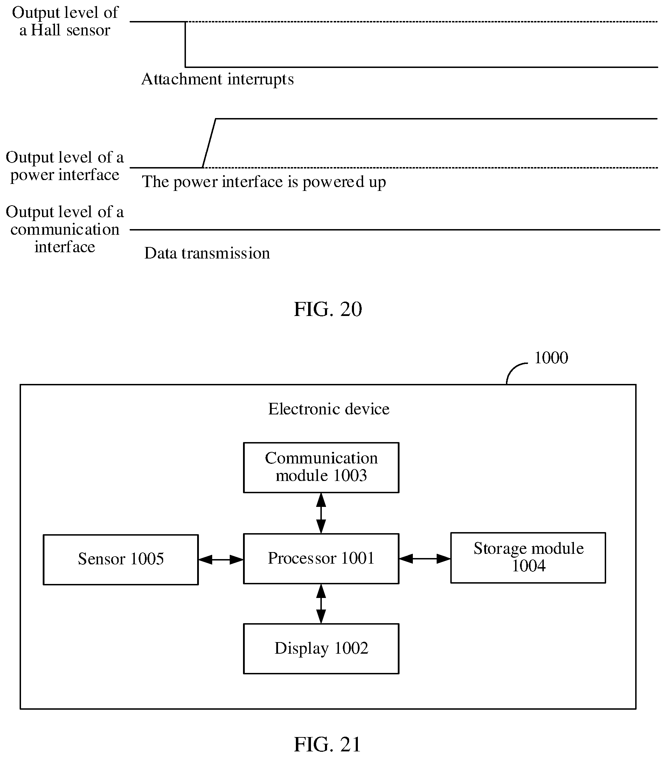

In the other case, there is no physical connection between the keyboard and the tablet computer currently, and another magnet enters the detection region of the Hall sensor of the tablet computer, causing the output level of the Hall sensor to change, resulting in mistaken triggering. FIG. 20 shows an example. When the magnet enters the detection region of the Hall sensor, the SOC detects that the output level of the Hall sensor changes from an initial high level to a low level, and controls the power interface to be powered up, and the output level of the power interface changes from an initial low level to a high level. However, within a period of time, the SOC does not receive the third response returned by the keyboard, in other words, the SOC detects that the output level of the communication interface always keeps at a low level. In this case, there may be mistaken triggering caused by another magnet entering the detection region of the Hall sensor of the tablet computer, and the SOC controls the power interface to be powered down, to avoid a short-circuit risk caused by a charged port. In addition, the icon of the keyboard is not displayed on the display interface. Optionally, there is also another case. For example, when the magnet enters the detection region of the Hall sensor, the SOC detects that the output level of the Hall sensor changes from an initial high level to a low level, and controls the power interface to be powered up, and the output level of the power interface changes from an initial low level to a high level. The SOC receives the third response returned by the keyboard, and the output level of the communication interface changes. However, the SOC checks data carried in the third response, and the data carried in the third response is abnormal. Correspondingly, the change rule of the output level of the communication interface also does not conform to the change rule agreed on by the communication protocol. In this case, the SOC determines that the communication connection of the communication interface is abnormal. To avoid the short-circuit risk caused by the charged port, the SOC also needs to control the power interface to be powered down in this case.

S111: The SOC sends the fourth instruction to the keyboard through the communication interface. If a fourth response is received S104 is performed. The SOC controls the display to display the icon of the keyboard on the display interface. If the fourth response is not received within fourth duration, S107 is performed. The SOC stops displaying the icon of the keyboard on the display and displays the reminding information on the display.

The fourth instruction may be the same as the second instruction. The fourth instruction may be a test instruction, or may be a communication instruction. If the SOC receives, within the fourth duration, the fourth response returned by the keyboard, the icon of the keyboard is displayed. Refer to the method provided in the embodiment of S104. Details are not described in this embodiment. If the SOC does not receive the fourth response returned by the keyboard within the fourth duration, the reminding information is displayed. Refer to the method provided in the embodiment of S107. Details are not described in this embodiment. The fourth duration may be the same as the third duration, and the fourth duration may be determined based on an actual instruction receiving/sending rate.

This embodiment of this application provides the external device detection method. A matching sensing apparatus that is physically connected is disposed in the electronic device and the external device, so that a status of a physical connection between the external device and the electronic device can be determined by using the sensing apparatus that is physically connected. The status of a communication connection between the external device and the electronic device is determined based on communication data between the pogo pin interface of the electronic device and the pogo pin interface of the external device. Based on the status of the physical connection and the status of the communication connection, an actual connection status of the external device may be continuously obtained. In addition, the electronic device may prompt, by outputting prompt information or outputting audio information on the display, the user that the external device has established a communication connection or does not establish a communication connection, so that the user can accurately sense the actual connection status of the external device in real time, thereby optimizing user experience.

In this embodiment, further, in a scenario in which a plurality of communication interfaces are configured for communication, according to an agreement of the communication protocol, when the electronic device determines that the physical connection between the external device and the electronic device is normal and a communication connection is not established, the electronic device may further investigate and position a specific abnormal communication interface or interfaces, to output information about a communication interface anomaly, so that the user can check and maintain the communication interface in a timely manner, and more accurate reminding information for abnormality resolution is provided for the user, thereby greatly optimizing user experience.

The foregoing embodiment is described by using an example in which the electronic device is a tablet computer having a display. In some embodiments, for an electronic device without a display, for example, when the electronic device is a wireless headset, and the external device is a headset charger, when detecting that the headset charger is disconnected from the headset charger, the wireless headset may prompt, by outputting audio, the user to adjust a position. For example, a beep sound is played, or voice prompt information is played. The external device detection method provided in the foregoing embodiment is applicable to all electronic devices and all external devices that have pogo pin interfaces.

The foregoing embodiment is described by using an example in which the electronic device senses an in-place state of the external device by using the Hall sensor and the magnet of the external device. Optionally, in some embodiments, the electronic device may alternatively sense an in-place state of the external device by using another sensor. For example, the electronic device may sense, by using an optical sensor, a distance sensor, a pressure sensor, an electric sensor, another magnetic sensor, and the like, whether the external device is physically connected to the electronic device. This is not limited in this embodiment.

The electronic device may output related information through a voice or an alert sound when the connection status of the external device changes. For example, when detecting that the external device is connected, the electronic device outputs a voice indicating that the external device has been connected. If detecting that the external device is disconnected, the electronic device outputs a voice indicating that the external device is disconnected, so that the user can directly obtain the connection status of the external device during use of the external device, thereby optimizing user experience.

In some embodiments, FIG. 21 is a schematic diagram of a structure of an electronic device 1000. The electronic device includes a processor 1001, a display 1002, a communication module 1003, a storage module 1004, and a sensor 1005.

The processor 1001 may be a central processing unit (central processing unit, CPU), a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The processor includes an application processor and a baseband processor. The processor may implement or execute various example logical blocks, modules, and circuits described with reference to content disclosed in this application. Alternatively, the processor may be a combination of processors implementing a computing function, for example, a combination of one or more microprocessors, or a combination of the DSP and a microprocessor. The communication module 1003 may be a transceiver, a transceiver circuit, or the like. The storage module may be a memory.

For example, the processor 1001 may be the processor 310 shown in FIG. 2, and the communication module 1003 includes a radio frequency module (a radio frequency module 350 shown in FIG. 2). The communication module may include a communication module (such as the communication module 360 shown in FIG. 2) such as a Wi-Fi module, a Bluetooth module, and a pogo pin communication module. The communication module and the storage module may be a memory (such as the internal memory 321 shown in FIG. 2). The display 1002 may be the display 394 shown in FIG. 2, the display 394 may be a touchscreen, and a display panel and a touch panel may be integrated in the touchscreen. The sensor may be the Hall sensor 380C, the pressure sensor 380A, the distance sensor 380F, the optical proximity sensor 380G, the ambient light sensor 380L, or the like shown in FIG. 2. A terminal in embodiments of this application may be the electronic device 100 shown in FIG. 2. The processor, the display, the communication module, the memory, the sensor, and the like may be connected together, for example, by using buses.

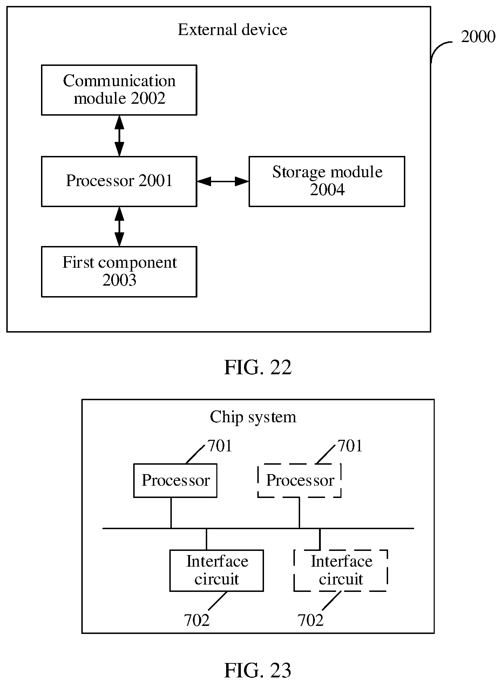

In some embodiments, FIG. 22 is a schematic diagram of a structure of an external device 2000. The electronic device includes a processor 2001, a communication module 2002, a first component 2003, and a storage module 2004.

The processor 2001 may be a CPU, a DSP, an ASIC, an FPGA, a microcontroller unit (microcontroller unit, MCU) or another programmable logic device, a transistor logic device, a hardware component, or any combination thereof. The processor includes an application processor and a baseband processor. The processor may implement or execute various example logical blocks, modules, and circuits described with reference to content disclosed in this application. Alternatively, the processor may be a combination of processors implementing a computing function, for example, a combination of one or more microprocessors, or a combination of the DSP and a microprocessor. The communication module 2003 may be a transceiver, a transceiver circuit, or the like. The storage module may be a memory.

For example, the processor 2001 may alternatively be the processor 410 shown in FIG. 4. The communication module 2002 may include a communication module (the communication module 430 shown in FIG. 4) such as a Wi-Fi module, a Bluetooth module, and a pogo pin communication module. The storage module may be a memory (the internal memory 421 shown in FIG. 4).

The first component 2002 may be a component matching a sensor in an electronic device. For example, if the electronic device 1000 includes the Hall sensor 380E, the first component is a magnet matching the Hall sensor 380E. The processor, the first component, the communication module, the memory, and the like that are provided in this embodiment of this application may be connected together, for example, by using buses.

An embodiment of this application further provides a chip system (for example, a system on a chip (system on a chip, SoC)). As shown in FIG. 23, the chip system includes at least one processor 701 and at least one interface circuit 702. The processor 701 may be interconnected to the interface circuit 702 through a line. For example, the interface circuit 702 may be configured to receive a signal from another apparatus (for example, a memory of an electronic device). For another example, the interface circuit 702 may be configured to send a signal to another apparatus (for example, the processor 701 or a camera of the electronic device). For example, the interface circuit 702 may read instructions stored in the memory and send the instructions to the processor 701. When the instruction is executed by the processor 701, the electronic device is enabled to perform the steps in the foregoing embodiments. Certainly, the chip system may further include other discrete devices. This is not specifically limited in embodiments of this application.

An embodiment of this application further provides a computer-readable storage medium. The computer-readable storage medium includes computer instructions. When the computer instructions are run on the foregoing electronic device, the electronic device is enabled to perform the functions or steps performed by the electronic device 100 in the foregoing method embodiments.

An embodiment of this application further provides a computer-readable storage medium. The computer-readable storage medium includes computer instructions. When the computer instructions are run on the foregoing electronic device, the external device 200 is enabled to perform the functions or steps performed by the external device in the foregoing method embodiments.

An embodiment of this application further provides a computer program product. When the computer program product runs on a computer, the computer is enabled to perform the functions or steps performed by the electronic device 100 in the foregoing method embodiments. For example, the computer may be the foregoing electronic device 100.

An embodiment of this application further provides a computer program product. When the computer program product runs on a computer, the computer is enabled to perform the functions or steps performed by the external device 200 in the foregoing method embodiments.

According to the descriptions of the foregoing implementations, a person skilled in the art may clearly understand that, for the purpose of convenient and brief description, the division into the foregoing functional modules is only used as an example for description. In actual application, the foregoing functions may be allocated to and completed by different functional modules based on needs. That is, an inner structure of an apparatus is divided into different functional modules to complete all or some of the functions described above.

In the several embodiments provided in this application, it should be understood that the disclosed apparatus and method may be implemented in other manners. For example, the described apparatus embodiment is merely an example. For example, the division into modules or units the is merely logical function division and may be other division in actual implementation. For example, a plurality of units or components may be combined or integrated into another apparatus, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may be one or more physical units, may be located in one place, or may be distributed on different places. Some or all of the units may be selected according to actual needs to achieve the objectives of the solutions of embodiments.

In addition, functional units in the embodiments of this application may be integrated into one processing unit, or each of the units may be physically separated, or two or more units may be integrated into one unit. The integrated unit may be implemented in the form of hardware, or may be implemented in a form of a software functional unit.

When the integrated unit is implemented in the form of a software functional unit and sold or used as an independent product, the integrated unit may be stored in a readable storage medium. Based on such an understanding, the technical solution of this application essentially, or the part contributing to the conventional technologies, or all or some of the technical solution may be implemented in the form of a software product. The software product is stored in a storage medium and includes several instructions for enabling a device (which may be a single-chip microcomputer, a chip or the like) or a processor (processor) to perform all or some of the steps of the method described in embodiments of this application. The foregoing storage medium includes any medium that can store program code, such as a USB flash drive, a removable hard disk, a read-only memory (read only memory, ROM), a random access memory (random access memory, RAM), a magnetic disk, or an optical disc.

What is described above is merely specific embodiments of this application, but the protection scope of this application is not limited to such embodiments. Any variation or replacement within the technical scope disclosed herein still fall within the protection scope of this application. Therefore, the protection scope of this application shall be subject to the protection scope of the claims.

## Claims

1. A pogo pin interface connection status detection method, applied to an electronic device, wherein the electronic device comprises a pogo pin interface and a sensor, the pogo pin interface comprises a communication interface, and the method comprises:
measuring, by the electronic device, a distance between an external device and the electronic device by using the sensor;
sending, by the electronic device, a first instruction to the external device through the communication interface if the distance is less than a preset threshold; and
sending, by the electronic device, first prompt information if the electronic device does not receive a first response within first duration, wherein the first prompt information prompts a user that a communication connection is not established between the external device and the electronic device.

2. The method according to claim 1, wherein the sending, by the electronic device, a first instruction to the external device through the communication interface comprises:
sending, by the electronic device, the first instruction to the external device through the communication interface based on a first periodicity.

3. The method according to claim 2, wherein before the sending, by the electronic device, first prompt information, the method further comprises:
sending, by the electronic device, a second instruction to the external device through the communication interface based on a second periodicity, wherein the second periodicity is shorter than the first periodicity; and
receiving, by the electronic device, no second response within second duration.

4. The method according to claim 3, wherein the method further comprises:
receiving, by the electronic device, the second response through the communication interface within the second duration, and displaying, by the electronic device, external device connection information.

5. The method according to any one of claims 1 to 4, wherein the method further comprises:
displaying, by the electronic device, the external device connection information if the electronic device receives the first response within the first duration.

6. The method according to any one of claims 1 to 5, wherein the sending, by the electronic device, first prompt information comprises:
stopping displaying, by the electronic device, the external device connection information; or
displaying, by the electronic device, the first prompt information on a display interface; or
playing, by the electronic device, the first prompt information.

7. The method according to any one of claims 1 to 6, wherein that the distance is less than the preset threshold comprises:
detecting, by the electronic device, that a high-low level jump occurs in a level of the sensor.

8. The method according to claim 7, wherein that the high-low level jump occurs in the level of the sensor comprises:
the level of the sensor changes from a high level to a low level; or
the level of the sensor changes from a low level to a high level; or
the level of the sensor restores to a low level after a high level interrupt is generated when the level of the sensor is at the low level; or
the level of the sensor restores to a high level after a low level interrupt is generated when the level of the sensor is at the high level.

9. The method according to claim 7, wherein the pogo pin interface further comprises a power interface, and after the detecting, by the electronic device, that a high-low level jump occurs in a level of the sensor, the method further comprises:
controlling, by the electronic device, the power interface to be powered up.

10. The method according to claim 9, wherein after the detecting, by the electronic device, that a high-low level jump occurs in a level of the sensor, the method further comprises:
sending, by the electronic device, a third instruction to the external device through the communication interface if the electronic device detects again that the high-low level jump occurs in the level of the sensor; and
controlling, by the electronic device, the power interface to be powered down if the electronic device does not receive a third response within third duration.

11. The method according to any one of claims 1 to 10, wherein before the sending, by the electronic device, first prompt information, the method further comprises:
sending, by the electronic device, a fourth instruction to the external device through the communication interface if the electronic device detects that the high-low level jump does not occur in the level of the sensor within a preset time period; and
receiving, by the electronic device, no fourth response within fourth duration.

12. The method according to any one of claims 1 to 11, wherein the method further comprises:
sending, by the electronic device, a fifth instruction to the external device through a first communication interface, wherein the first communication interface is any one of a plurality of communication interfaces; and
displaying, by the electronic device, second prompt information if the electronic device receives a fifth response not through the first communication interface within fifth duration, wherein the second prompt information prompts that the first communication interface is abnormal.

13. The method according to any one of claims 1 to 12, wherein the sensor is any one of a Hall sensor, an infrared sensor, a distance sensor, a pressure sensor, an optical proximity sensor, and an ambient light sensor.

14. A combination apparatus of an electronic device and an external device, wherein the combination apparatus comprises the electronic device and the external device;
the electronic device comprises a processor, a sensor, and a pogo pin interface, the pogo pin interface comprises a communication interface, and the processor is configured to perform the method according to any one of claims 1 to 13;
the external device comprises a processor and a pogo pin interface, and the pogo pin interface comprises a communication interface; and
when the electronic device is physically connected to the external device, a position of the pogo pin interface of the electronic device is aligned with a position of the pogo pin interface of the external device.

15. The combination apparatus according to claim 14, wherein if the sensor of the electronic device is a Hall sensor, the external device further comprises a first component, and the first component is a magnet; and
when the electronic device is physically connected to the external device, the magnet is located in a detection region of the Hall sensor.

16. An electronic device, wherein the electronic device comprises a memory, a sensor, a pogo pin interface, a display, and one or more processors, the memory, the sensor, the pogo pin interface, the display are coupled to the processor, the memory stores computer program code, the computer program code comprises computer instructions, and when the computer instructions are executed by the processor, the electronic device is enabled to perform the method according to any one of claims 1 to 13.

17. A computer-readable storage medium, comprising computer instructions, wherein when the computer instructions are run on an electronic device, the electronic device is enabled to perform the method according to any one of claims 1 to 13.
